# EUROPÄISCHE PATENTSCHRIFT

(11) **EP 3 499 941 B1**
(45) Veröffentlichungstag und Bekanntmachung des Hinweises auf die Patenterteilung: **22.12.2021**
(21) Anmeldenummer: 17207785.1
(22) Anmeldetag: 15.12.2017
(51) Int. Cl.: H04W 24/08, H04W 24/04

(54) **VORRICHTUNG UND VERFAHREN ZUR DOMÄNEN-ÜBERGREIFENDEN ANALYSE VON FUNKSYSTEMEN**
DEVICE AND METHOD FOR CROSS-DOMAIN ANALYSIS OF WIRELESS SYSTEMS
DISPOSITIF ET PROCÉDÉ D'ANALYSE PAR CHEVAUCHEMENT DES DOMAINES DES SYSTÈMES RADIO

(43) Veröffentlichungstag der Anmeldung: 19.06.2019
(73) Patentinhaber: Fraunhofer-Gesellschaft zur Förderung der angewandten Forschung e.V., 80686 München (DE)
(72) Erfinder: WETZKER, Ulf, 01324 Dresden (DE); FROTZSCHER, Andreas, 01097 Dresden (DE); SPLITT, Ingmar, 01307 Dresden (DE)
(74) Vertreter: Schairer, Oliver

(56) Entgegenhaltungen:
- US-A1- 2005 073 983
- US-A1- 2005 227 625

## Beschreibung

Die Anmeldung betrifft Funksystemtechnologien und, im Besonderen, eine Vorrichtung und ein Verfahren zur Domänen-übergreifenden Analyse von Funksystemen. Speziell betrifft die Anmeldung die Zustandsanalyse und Störungsdiagnose in industriellen Funksystemen, kommerziellen Funksystemen als auch privaten Funksystemen.

In vielen Bereichen werden heutzutage Funkkommunikationssysteme eingesetzt, beispielsweise in der Industrieautomation zur datentechnischen Anbindung mobiler oder beweglicher Subsysteme an übergeordnete Systeme, in unterschiedlichen Unternehmensbereichen, sowie im großen öffentlichen Bereichen wie etwa in Bahnhöfen, Flughäfen, Messehallen und Krankenhäuser. Viele der eingesetzten Funksysteme nutzen die lizenzfreien Frequenzbänder, z.B. die ISM Frequenzbänder (Industrial, Scientific and Medical Band; deutsch: industrielles, wissenschaftliches und medizinisches Band) oder die UNII Frequenzbänder (Unlicensed National Information Infrastructure; deutsch: unlizensierte nationale Informations-Infrastruktur).

Bei der Nutzung der lizenzfreien Frequenzbändern kommt es aber zu Problemen. Einerseits werden die Frequenzbänder durch eine Vielzahl von Funkprotokollen (beispielsweise Bluetooth, WiFi, usw.) sowie auch andere technische Anlagen (wie z.B. durch eine Mikrowelle) genutzt. Da der Zugriff räumlich benachbarte Funknetzwerke auf das Funkmedium nicht zentral koordiniert wird, können wechselseitige Störungen zwischen den Funknetzwerken entstehen, die als Koexistenzprobleme bezeichnet werden. Hierzu gehören die zeitliche, räumliche und spektrale Überlagerung von verschiedenen Funksignalen und teilweise die Verzögerung der Aussendung eines Funksignales durch die Belegung des Funkkanals durch ein anderes Funksignal.

Des Weiteren stellt ein Problem dar, dass die Anwendung, welche die Funkvernetzung nutzt, keine oder sehr wenig Information über den Zustand des Funkübertragungssystems erhält. Die eingesetzten Funkkomponenten verfügen über keine oder nicht ausreichende Möglichkeiten zur Überwachung des Zustands der Funkvernetzung, da ihre verfügbaren Hardwareressourcen sehr begrenzt sind. Im Falle von Übertragungsstörungen sind die Funkkomponenten nicht in der Lage, die Ursache von Übertragungsstörungen selbstständig zu identifizieren.

Zur Lösung der obigen Probleme werden im Stand der Technik unter anderem Spektralanalysatoren eingesetzt: Die Bedienung der Messgeräte und Interpretation der Messergebnisse erfolgt manuell und erfordert fundierte Kenntnisse zu Funksystemen. Damit kann jedoch nur grob erkannt werden, welche Funkprotokolle das gemessene Funkfrequenzband nutzen und mit welcher Empfangsleistung die Funkprotokolle gemessen werden. Mit diesem Lösungsansatz können jedoch keine weiterführende Informationen (z.B. Auslastung des Frequenzbandes, zeitliche Dauer der Funksignale, Adressen der Funcknoten) erfasst werden. Beispiel eines Spektralanalysators ist etwa der RSA7100A Spectrum Analyzer von Tektronix (siehe [3]: https://www.tek.com/datasheet/rsa7100a : RSA7100A).

Ein weiterer Ansatz im Stand der Technik ist der Einsatz von Protokollanalysatoren. Protokollanalysatoren aus dem Stand der Technik sind auf ein Funkprotokoll zugeschnitten (z.B. WiFi) und analysieren die Inhalte aufgezeichneter Funkpakete. Durch die Beschränkung auf ein spezifisches Funkprotokoll und die Auswertung der Funkpaketinhalte sind die Protokollanalysatoren nicht in der Lage wechselseitige Störungen (Koexistenzprobleme) zwischen benachbarten Funksystemen unterschiedlicher Funkprotokolle zu identifizieren. Beispiele von Protokollanalysatoren sind etwa die WiFi Analysatoren: NetScout - AirMagnet (siehe [4]: http://enterprise-de.netscout.com/enterprise-network/wirelessnetwork/AirMagnet-WiFi-Analyzer)

Des Weiteren sind aus dem Stand der Technik Kombinationen von Spektrumanalysator und WiFi Protokollanalysator bekannt. Ein Beispiel hierfür ist der NetScout - AirMagnet Spectrum XT (siehe [5]: http://enterprise-de.netscout.com/content/datasheet-airmagnetspectrum-xt ). Diese Lösung analysiert das Funkspektrum automatisch und erkennt anhand von Mustern Funkprotokollen (z.B. WiFi, Bluetooth etc.). Diese Informationen werden in der Protokollanalyse sichtbar gemacht. Eine detaillierte Spektralanalyse jedes Funksignals und eine darauf aufbauende Auswertung z.B. hinsichtlich der Kanalauslastung oder Verteilung der Empfangsleistung pro Funkprotokoll findet nicht statt.

US 7 184 777 B2 (siehe [6]) bezieht sich auf das Management der Nutzung des Funkfrequenzspektrums durch Identifikation, Klassifikation und Lokalisierung von Aussendungen in einem Funkfrequenzband. Ein verteiltes System von "Radio Sensor Devices", die jeweils aus einem HF-Empfänger mit angeschlossener Spektrogramm-Analyse und einem weiteren HF-Empfänger mit einem Demodulator für ein bestimmtes Funkprotokoll bestehen, wird dargestellt. Eine Spektrogramm-Analyse liefert Informationen zur Nutzung des überwachten Funkfrequenzbandes (sog. Aktivitätsinformationen).

EP 3 170 333 A1 (siehe [7]) offenbart ein System aus verteilten Spektrogramm-Analyse-Knoten. In einigen Beispielen umfasst das drahtlose Spektrogramm-Analysesystem Funkspektrumanalysegeräte, die an verschiedenen Orten über eine geografische Region verteilt sind. Die Funkspektrumanalysegeräte sind so konfiguriert, dass sie gleichzeitig die Funkspektrumnutzung an jedem einzelnen Ort überwachen.

US 2003 0198200 A1 (siehe [8]) betrifft die Durchführung einer Spektrogramm-Analyse und Nutzung der Informationen zum Management mehrerer Funkknoten. Es werden Informationen zur Nutzung des überwachten Funkfrequenzbandes berechnet, und diese sogenannten Aktivitätsinformationen werden für die Steuerung und das Management von Funkknoten benutzt.

US 2009 0052500 A1 (siehe [9]) zeigt eine Vorrichtung, die einen Spektrumanalysator und eine Entscheidungsschaltung umfasst. Der Spektrumanalysator ist konfiguriert, um drahtlose Signalsignaturdaten aus einem breiten Bereich von Frequenzbändern zu ermitteln.

US 2007 0264939 A1 (siehe [10]) zeigt ein Verfahren zum Identifizieren von Geräten, wobei Pulsmetrikdaten Eigenschaften repräsentieren, die mit Impulsen von empfangener Funkfrequenz-Energie assoziiert sind. Die Pulse werden basierend auf ihren Pulsmetrikdaten in Gruppen unterteilt, so dass eine Gruppe Pulse mit Ähnlichkeiten für mindestens eine Pulsmetrikdateneinheit umfasst..

In [1] wurde erstmalig ein Hardware-Vorschlag für ein Funkanalysegerät vorgestellt, der neben einem Modul zur Spektralanalyse separate Empfangsmodule für drei unterschiedliche Funkprotokollen, WiFi, Bluetooth, IEEE 802.15.4 enthält. Der in [1] dargestellte Vorschlag einer Spektralanalyse und Protokollanalyse wurde auch in [2] vorgestellt.

US2005073983 und US2005227625 offenbaren eine Vorrichtung (genannt Sensor) zur Analyse eines oder mehrerer Funksysteme (nämlich eines WLAN-Systems und anderer Funksysteme). Insbesondere umfasst die Vorrichtung: einen Verkehrsüberwachungsabschnitt, der auf WLAN-Signale innerhalb eines vordefinierten Teils des unlizenzierten Spektrums überwacht; und einen Spektrumüberwachungsabschnitt, der auf andere Signale innerhalb des vordefinierten Abschnitts des unlizenzierten Spektrums überwacht; und einen Prozessor, der sowohl mit dem Verkehrsüberwachungsabschnitt als auch mit dem Spektrumüberwachungsabschnitt gekoppelt ist.

Eine Vorrichtung nach Anspruch 1, eine Verfahren nach Anspruch 15 und ein Computerprogramm nach Anspruch 16 werden bereitgestellt.

Eine Vorrichtung zur Analyse von einem oder mehreren Funksystemen gemäß einer Ausführungsform wird bereitgestellt.

Die Vorrichtung umfasst ein oder mehrere Hochfrequenz-Baugruppen zur Erzeugung eines oder mehrerer Basisbandsignale aus einem oder mehreren Funksignalen.

Ferner umfasst die Vorrichtung ein Spektralanalysemodul zur Durchführung einer Spektralanalyse, wodurch eines der ein oder mehreren Basisbandsignale in eine Zeit-Frequenz Domäne transformiert wird, um ein Spektrogramm in der Zeit-Frequenz Domäne zu erhalten.

Des Weiteren umfasst die Vorrichtung ein oder mehrere Demodulatoren zur Erzeugung von zwei oder mehr demodulierten Funkpaketen der ein oder mehreren Funksysteme aus den ein oder mehreren Basisbandsignalen, wobei die ein oder mehreren Demodulatoren ferner ausgebildet sind, Zusatzinformationen zu jedem der zwei oder mehreren demodulierten Funkpakete bereitzustellen.

Darüber hinaus umfasst die Vorrichtung einen Spektrogramm-Analysator zur Detektion von zwei oder mehreren aufgefundenen Funkpaketen in dem Spektrogramm in der Zeit-Frequenz Domäne und zur Ermittlung von ein oder mehreren Eigenschaften für jedes der zwei oder mehreren aufgefundenen Funkpakete basierend auf dem Spektrogramm in der Zeit-Frequenz Domäne.

Ferner umfasst die Vorrichtung ein Synchronisationsmodul, das ausgebildet ist, ein oder mehrere Paare zu bestimmen, wobei jedes der ein oder mehreren Paare genau ein demoduliertes Funkpaket der zwei oder mehr demodulierten Funkpakete aufweist und das die ein oder mehreren Eigenschaften von genau einem aufgefundenen Funkpaket der zwei oder mehreren aufgefundenen Funkpakete aufweist. Dabei ist das Synchronisationsmodul ausgebildet, jedes der ein oder mehreren Paare so zu bestimmen, dass die ein oder mehreren Eigenschaften desjenigen in dem Spektrogramm aufgefundenen Funkpakets der zwei oder mehreren aufgefundenen Funkpakete mit dem demodulierten Funkpaket des Paares in dem Paar verknüpft werden, das dem demodulierten Funkpaket des Paares entspricht.

Ferner ist das Synchronisationsmodul ausgebildet, jedes der ein oder mehreren Paare in Abhängigkeit von den Zusatzinformationen der zwei oder mehreren demodulierten Funkpakete und in Abhängigkeit von den Eigenschaften der zwei oder mehreren aufgefundenen Funkpakete zu bestimmen. Das Synchronisationsmodul ist ausgebildet, die ein oder mehreren Paare oder Informationen, die von den ein oder mehreren Paaren abhängen, auszugeben.

Ausführungsformen der Erfindung basieren auf einer Kombination der Ergebnisse der Spektrogramm-Analyse und Analyse der demodulierten Funkpakete. Dabei werden in manchen Ausführungsformen Daten von verschiedenen Empfangsmodule verarbeitet.

Ausführungsformen der Erfindung tragen z.B. dazu bei, die Übertragungsqualität und/oder die Stabilität und/oder Zuverlässigkeit zu überwachen und Störungen zu detektieren und/oder zu diagnostizieren.

Des Weiteren realisieren Ausführungsformen der Erfindung ein frühzeitiges Erkennen von in den Funkverbindungen auftretende Störungen und Identifizieren deren Ursachen. So können in manchen Ausführungsformen Ausbreitungsprobleme, Interferenzen zwischen konkurrierenden Funkverbindungen bzw. durch Störemissionen, sowie auch Hardware und Software-Defekte in den Funkkomponenten als mögliche Ursachen erkannt werden.

Ausführungsformen sehen eine Kombination der Information aus einzelnen demodulierten Funkpaketen mit Informationen aus der Spektrogramm-Analyse vor.

In Ausführungsformen werden die demodulierten Funkpakete mit Informationen aus ihrem jeweiligen spektralen Abbilder kombiniert, Überlagerungen von Funksignalen erkannt und daraus abgeleitete Informationen mit den demodulierten Funkpaketen verknüpft. Es wird in Ausführungsformen somit eine Kombination der Informationen aus der Spektrogramm-Analyse und den demodulierten Funkpaketen auf Paket-Ebene bereitgestellt.

In Ausführungsformen werden somit Informationen zur Nutzung des überwachten Funkfrequenzbandes verwendet, wobei diese Informationen, die als Aktivitätsinformationen bezeichnet werden können, für die Steuerung und das Management von Funkknoten eingesetzt werden.

Des Weiteren werden Konzepte der Analyse des Funkfrequenzspektrums vorgestellt, die zeitliche, räumliche und spektrale Überlagerungen von Funksignalen erkennt. Diese Informationen werden nachfolgend mit den Informationen der jeweils betroffenen, demodulierten Funkpakete verknüpft.

In manchen Ausführungsformen der Erfindung enthalten spektrale Daten Informationen aus höheren Protokollschichten. Manche Ausführungsformen umfassen eine Spektrogramm-Analyse und eine Protokollanalyse. Manche Ausführungsformen sehen separate Hardware-Komponenten für die Erfassung des Funkfrequenzbandes und die Erfassung und ggf. auch Demodulation der Funkpakete vor. In bevorzugten Ausführungsformen wird kein verteiltes System aus Funkanalyse-Knoten vorausgesetzt.

Verfahren zur Analyse von einem oder mehreren Funksystemen. Das Verfahren umfasst:
- Erzeugung eines oder mehrerer Basisbandsignale aus einem oder mehreren Funksignalen.
- Durchführung einer Spektralanalyse, wodurch eines der ein oder mehreren Basisbandsignale in eine Zeit-Frequenz Domäne transformiert wird, um ein Spektrogramm in der Zeit-Frequenz Domäne zu erhalten.
- Erzeugung von zwei oder mehr demodulierten Funkpaketen der ein oder mehreren Funksysteme aus den ein oder mehreren Basisbandsignalen, und Bereitstellung von Zusatzinformationen zu jedem der zwei oder mehreren demodulierten Funkpakete.
- Detektion von zwei oder mehreren aufgefundenen Funkpaketen in dem Spektrogramm in der Zeit-Frequenz Domäne, und Ermittlung von ein oder mehreren Eigenschaften für jedes der zwei oder mehreren aufgefundenen Funkpakete basierend auf dem Spektrogramm in der Zeit-Frequenz Domäne. Und:
- Bestimmung von ein oder mehreren Paaren, wobei jedes der ein oder mehreren Paare genau ein demoduliertes Funkpaket der zwei oder mehr demodulierten Funkpakete aufweist und das die ein oder mehreren Eigenschaften von genau einem aufgefundenen Funkpaket der zwei oder mehreren aufgefundenen Funkpakete aufweist, wobei jedes der ein oder mehreren Paare so bestimmt wird, dass die ein oder mehreren Eigenschaften desjenigen in dem Spektrogramm aufgefundenen Funkpakets der zwei oder mehreren aufgefundenen Funkpakete mit dem demodulierten Funkpaket des Paares in dem Paar verknüpft werden, das dem demodulierten Funkpaket des Paares entspricht, wobei jedes der ein oder mehreren Paare in Abhängigkeit von den Zusatzinformationen der zwei oder mehreren demodulierten Funkpakete und in Abhängigkeit von den Eigenschaften der zwei oder mehreren aufgefundenen Funkpakete bestimmt wird; und Ausgabe der ein oder mehreren Paare oder von Informationen, die von den ein oder mehreren Paaren abhängen.

Ferner wird ein Computerprogramm mit einem Programmcode zur Durchführung des obigen Verfahrens bereitgestellt.

Nachfolgend werden bevorzugte Ausführungsformen der Erfindung unter Bezugnahme auf die Zeichnungen beschrieben.

In den Zeichnungen ist dargestellt:
- Fig. 1: zeigt eine Vorrichtung zur Analyse von einem oder mehreren Funksystemen gemäß einer Ausführungsform.
- Fig. 2: zeigt eine Erfassung der Empfangssignale in einem Funkfrequenzband mittels einer einzelnen HF-Komponente.
- Fig. 3: zeigt eine Erfassung der Empfangssignale in einem Funkfrequenzband mittels mehrerer HF-Komponenten.
- Fig. 4: zeigt eine Übersicht eines Konzepts zur Domänen-übergreifenden Analyse von Funksystemen gemäß einer Ausführungsform.
- Fig. 5: zeigt einen zeigt einen Spektrogramm-Analysator zur automatischen Spektrogramm-Analyse gemäß einer beispielhaften Ausführungsform.
- Fig. 6: zeigt ein Synchronisationsmodul zum Abgleich der Daten der Spektrogramm-Analyse mit den demodulierten Funkpaketen gemäß einer ersten Gruppe bevorzugter Ausführungsformen.
- Fig. 7: zeigt ein Synchronisationsmodul zum Abgleich der Daten der Spektrogramm-Analyse mit den demodulierten Funkpaketen gemäß einer zweiten Gruppe bevorzugter Ausführungsformen.
- Fig. 8: zeigt ein Blockschaltdiagramm zur Berechnung des virtuellen Spektrogramms der demodulierten Funkpakete gemäß einem Ausführungsbeispiel.
- Fig. 9: zeigt ein Spektrogramm in der Zeit-Frequenz Domäne, in der eine Vielzahl von Funkpaketen dargestellt sind.
- Fig. 10a: zeigt zwei Funkpakete in der Zeit-Frequenz Domäne, die nicht miteinander kollidieren.
- Fig. 10b: zeigt zwei Funkpakete in der Zeit-Frequenz Domäne, die miteinander kollidieren.
- Fig. 11a: zeigt eine zweidimensionale Darstellung des Spektrogramms für ein Funkpaket mit dem Leistungsdichtespektrum des Funkpakets, wobei das Leistungsdichtespektrum des Funkpakets störungsfrei ist.
- Fig. 11b: zeigt eine zweidimensionale Darstellung des Spektrogramms für ein Funkpaket mit dem Leistungsdichtespektrum des Funkpakets, wobei das Leistungsdichtespektrum des Funkpakets störungsbehaftet ist.
- Fig. 12a: vergleicht ein erstes tatsächliches Leistungsdichtespektrum mit einer ersten spektralen Maske, wobei das erste tatsächliche Leistungsdichtespektrum der ersten vordefinierten spektralen Maske entspricht.
- Fig. 12b: vergleicht ein zweites tatsächliches Leistungsdichtespektrum mit einer zweiten spektralen Maske, wobei das zweite tatsächliche Leistungsdichtespektrum der zweiten vordefinierten spektralen Maske nicht entspricht.

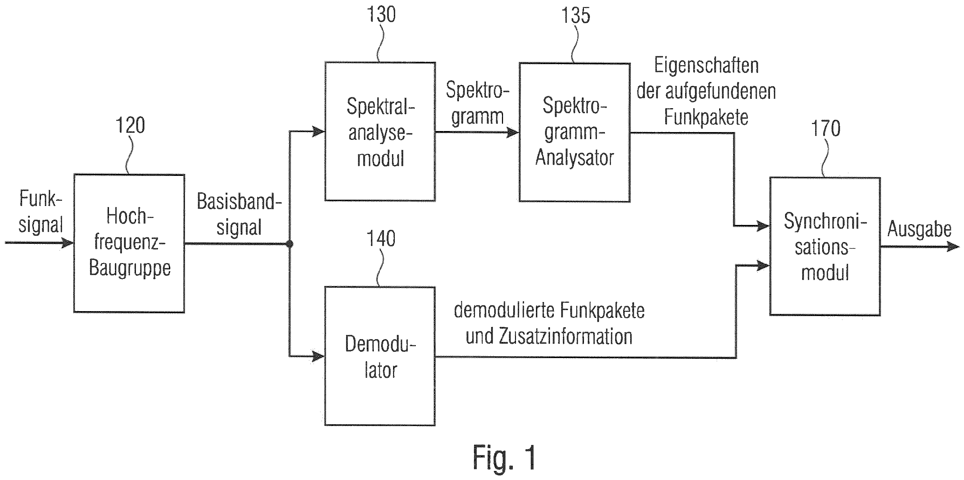

Fig. 1 zeigt eine Vorrichtung zur Analyse von einem oder mehreren Funksystemen gemäß einer Ausführungsform.

Die Vorrichtung umfasst ein oder mehrere Hochfrequenz-Baugruppen 120 zur Erzeugung eines oder mehrerer Basisbandsignale aus einem oder mehreren Funksignalen.

Ferner umfasst die Vorrichtung ein Spektralanalysemodul 130 zur Durchführung einer Spektralanalyse, wodurch eines der ein oder mehreren Basisbandsignale in eine Zeit-Frequenz Domäne transformiert wird, um ein Spektrogramm in der Zeit-Frequenz Domäne zu erhalten.

Des Weiteren umfasst die Vorrichtung ein oder mehrere Demodulatoren 140 zur Erzeugung von zwei oder mehr demodulierten Funkpaketen der ein oder mehreren Funksysteme aus den ein oder mehreren Basisbandsignalen, wobei die ein oder mehreren Demodulatoren 140 ferner ausgebildet sind, Zusatzinformationen zu jedem der zwei oder mehreren demodulierten Funkpakete bereitzustellen.

Darüber hinaus umfasst die Vorrichtung einen Spektrogramm-Analysator 135 zur Detektion von zwei oder mehreren aufgefundenen Funkpaketen in dem Spektrogramm in der Zeit-Frequenz Domäne und zur Ermittlung von ein oder mehreren Eigenschaften für jedes der zwei oder mehreren aufgefundenen Funkpakete basierend auf dem Spektrogramm in der Zeit-Frequenz Domäne.

Ferner umfasst die Vorrichtung ein Synchronisationsmodul 170, das ausgebildet ist, ein oder mehrere Paare zu bestimmen, wobei jedes der ein oder mehreren Paare genau ein demoduliertes Funkpaket der zwei oder mehr demodulierten Funkpakete aufweist und das die ein oder mehreren Eigenschaften von genau einem aufgefundenen Funkpaket der zwei oder mehreren aufgefundenen Funkpakete aufweist.

Dabei ist das Synchronisationsmodul 170 ausgebildet, jedes der zwei oder mehreren Paare so zu bestimmen, dass die ein oder mehreren Eigenschaften desjenigen in dem Spektrogramm aufgefundenen Funkpakets der zwei oder mehreren aufgefundenen Funkpakete mit dem demodulierten Funkpaket des Paares in dem Paar verknüpft werden, das dem demodulierten Funkpaket des Paares entspricht.

Ferner ist das Synchronisationsmodul 170 ausgebildet, jedes der zwei oder mehreren Paare in Abhängigkeit von den Zusatzinformationen der zwei oder mehreren demodulierten Funkpakete und in Abhängigkeit von den Eigenschaften der zwei oder mehreren aufgefundenen Funkpakete zu bestimmen. Das Synchronisationsmodul 170 ist ausgebildet, die zwei oder mehreren Paare oder Informationen, die von den zwei oder mehreren Paaren abhängen, auszugeben.

Manche Ausführungsformen der Erfindung basieren auf der Erfassung aller Funksignale in einem betrachteten Funkfrequenzbandes, der Überführung der Funksignale in den Spektralbereich mit der anschließenden Spektralanalyse der Funksignale, sowie der Demodulation der Funksignale zur Gewinnung ihrer digitalen Inhalte.

Eine Kollision kann z.B. durch eine zeitliche, spektrale und räumliche Überlagerung zweier Funkpakete definiert sein. (Zeitliche Überlagerung: Überlagerung in der Zeit; spektrale Überlagerung: Überlagerung in der Frequenz; örtliche Überlagerung: Die Funksignale überlagern sich auch örtlich, also beeinträchtigen sich gegenseitig und sind nicht räumlich so weit voneinander entfernt, dass es zu keiner Beeinträchtigung kommt.)

In manchen der Ausführungsformen wird in dem Spektrogramm wird eine Kollision (räumliche, zeitliche und spektrale Überlagerung) zwischen zwei Funkpaketen (z.B. Paket a von Funkprotokoll 1 und z.B. Paket b von Funkprotokoll 2) detektiert, wobei in der Vorrichtung beispielsweise nur für eines der Funkpakete (z.B. Paket a) ein geeigneter Demodulator zur Verfügung steht. In solchen Ausführungsformen kann beispielsweise die Auswertung des Paketes a die Zusatzinformation umfassen, dass das Paket a mit einem Funkpaket kollidierte und dass das andere Funkpaket von einem Funkknoten des Funkprotokolls 2 ausgesandt wurde. So kann das Synchronisationsmodul 170 beispielsweise ausgebildet sein, eine Information über ein Funkprotokoll eines anderen Funkpakets auszugeben, mit dem das aufgefundene Funkpaket, das dem demodulierte Funkpaket dieses Paares entspricht, eine Kollision gehabt hat.

Zur besseren Unterscheidung wird nachfolgend als Funksignal das hochfrequente Empfangssignal am Ausgang der HF-Baugruppe des Funkempfängers verstanden, das von einem Funkknoten ausgesandt wurde. Als Funkpaket wird das Ergebnis bezeichnet, das die erfolgreichen Demodulation des empfangene Funksignals entsprechend des eingesetzten Funkprotokolls liefert. Zudem können technischen Anlagen Störemissionen in den betrachteten Funkfrequenzbändern verursachen.

In Ausführungsformen der Erfindung kann z.B. eine kombinierte Analyse der erfassten Informationen aus beiden Domänen (Spektralbereich und Funkprotokollebene) eingesetzt werden. Es kann somit ausgenutzt werden, dass jedes Funkpaket auf mehreren Ebenen erfasst und analysiert werden kann. In Ausführungsformen handelt es sich bei den angesprochenen Ebenen beispielsweise um die Spektralebene oder z.B. um die Bitübertragungsschicht (OSI Schicht 1) oder z.B. um die Sicherungsschicht (OSI Schicht 2) oder z.B. um die Vermittlungsschicht (OSI Schicht 3) oder z.B. um die Transportschicht (OSI Schicht 4) oder z.B. um die Anwendungsschicht (OSI Schicht 7) (OSI = Open Systems Interconnection; deutsch: Verbindung offener Systeme).

In Ausführungsformen der Erfindung können die erfassten Funksignale von einem einzelnen Funknetzwerk eines bestimmten Funkprotokolls oder von mehreren Funknetzwerken des gleichen Funkprotokolls oder von mehreren Funknetzwerken unterschiedlicher Funkprotokollen stammen.

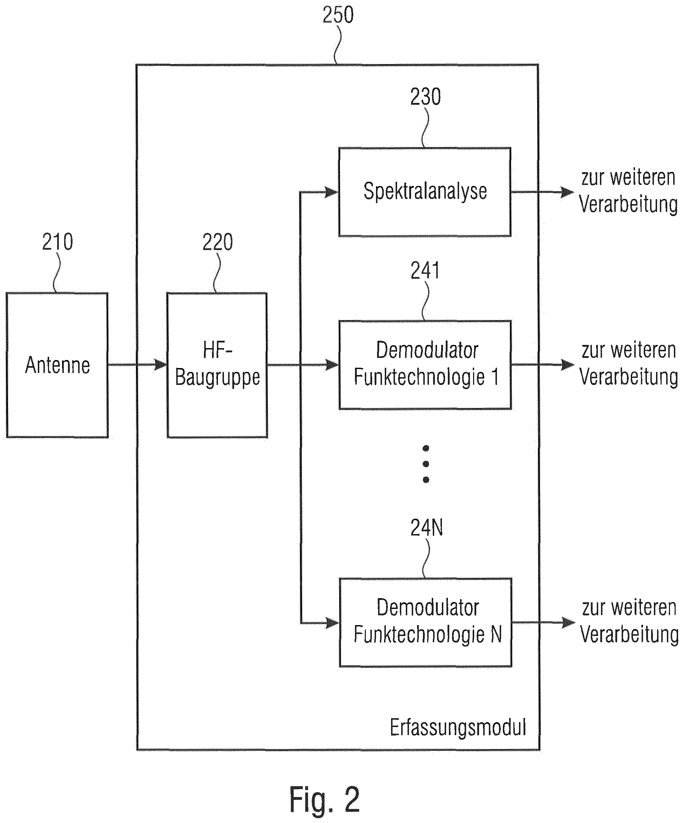

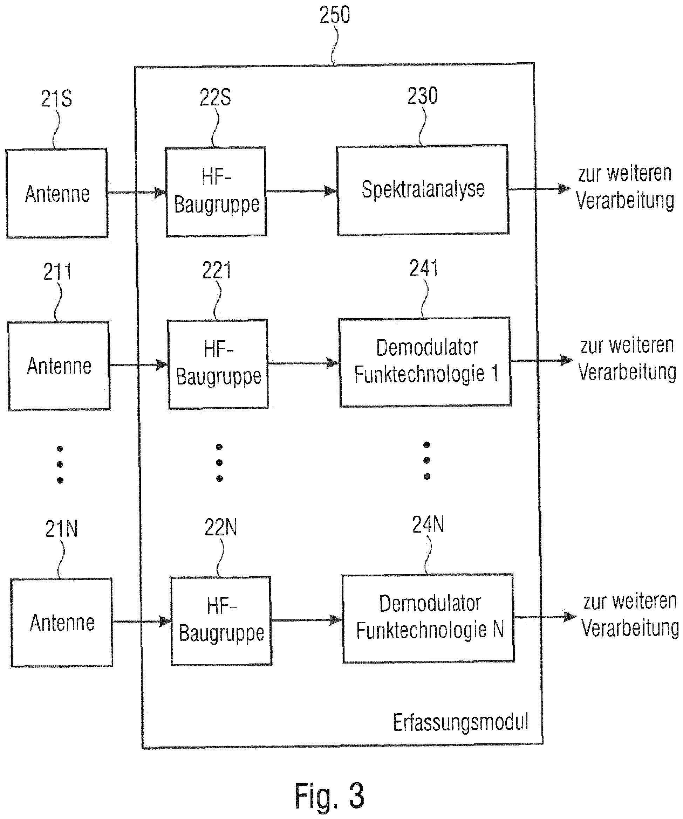

Gemäß Ausführungsformen der Erfindung wird das erfasste Empfangssignal des zu analysierenden Funkfrequenzband einer einzelnen Hardware-Komponente oder mehreren Hardware-Komponenten zur Spektralanalyse und zur Demodulation der Funkpakete zugeführt. Dabei können pro Funkprotokoll je ein oder auch mehrere Demodulatoren eingesetzt werden. In Fig. 2 und Fig. 3 sind zwei Ausführungsmöglichkeiten dargestellt.

So zeigt Fig. 2 eine Erfassung der Empfangssignale in einem Funkfrequenzband mittels einer einzelnen HF-Komponente. Ein Empfangssignal wird mittels Antenne 210 empfangen und von einer HF-Baugruppe 220 (Hochfrequenz-Baugruppe) verarbeitet, die dann das verarbeitete Signal in ein Spektralanalysemodul 230 und in einen oder mehrere Demodulatoren 241 bis 24N eingespeist. Beispielsweise kann die Hochfrequenz-Baugruppe 220 ausgelegt sein, aus dem HF-Signal (Hochfrequenz-Signal) ein Basisbandsignal zu erzeugen.

Die HF-Baugruppe 220, das Spektralanalysemodul 230 und die ein oder mehreren Demodulatoren 241 bis 24N können Teil eines Erfassungsmoduls 250 sein. Das Spektralanalysemodul 230 ist dafür ausgelegt, eine Spektralanalyse auf dem empfangenen Signal durchzuführen. Die Demodulatoren 241 bis 24N sind dafür ausgelegt, das empfangene Signal zu demodulieren.

Des Weiteren ist in Fig. 3 eine Erfassung der Empfangssignale in einem Funkfrequenzband mittels mehrerer HF-Komponenten gezeigt. Im Beispiel der Fig. 3 wird das Empfangssignal mittels der Antennen 21S, 211, ..., 21N empfangen und von N+1 Hochfrequenz-Baugruppen 22S, 221, ..., 22N verarbeitet, die dann das jeweils verarbeitete Signal in das Spektralanalysemodul 230 und in die N Demodulatoren 241 bis 24N einspeisen.

Die Erfassung des Empfangssignals und anschließenden Spektralanalyse oder Demodulation der Funkpakete kann dabei mit einem einzelnen Hardware-Modul bzw. Gerät erfolgen oder mittels mehrerer Hardware-Module bzw. mittels mehrerer Geräte realisiert werden. Ebenso kann die Analyse auf einem der zur Erfassung genutzten Hardware-Modulen erfolgen oder auf einem zentralen Computersystem integriert sein.

In manchen Ausführungsformen ist die Antenne 210 der Fig. 2 bzw. sind die Antennen 21S, 211, 21N der Fig. 3 nicht Teil der Vorrichtung nach Fig. 1. In anderen, alternativen Ausführungsformen umfasst die Vorrichtung der Fig. 1 des Weiteren die ein oder mehrere Antennen 210; 21S, 211, 21N zum Erfassen von ein oder mehreren Funksignalen.

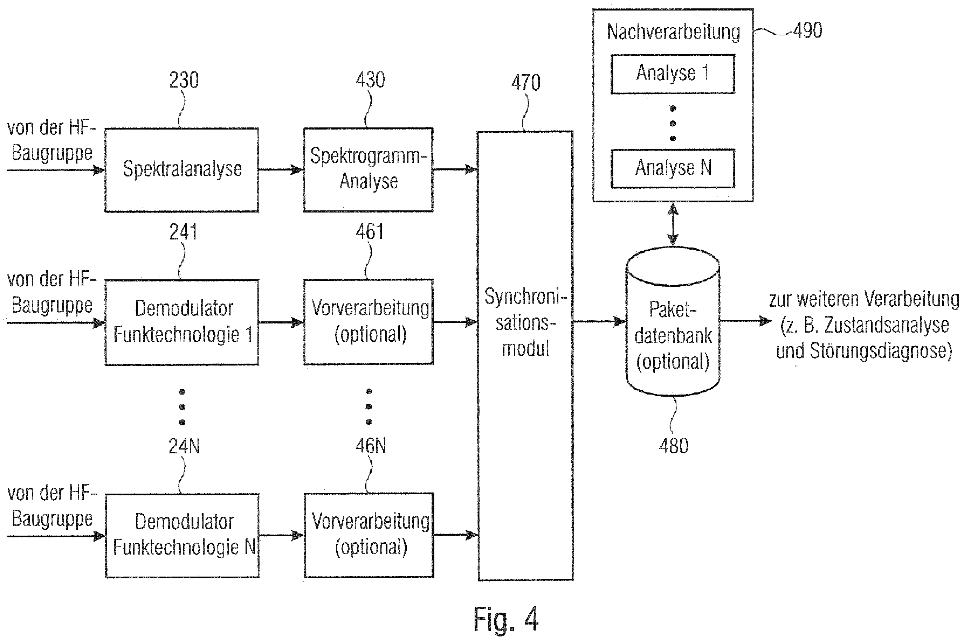

Fig. 4 zeigt eine Übersicht eines Konzepts zur Domänen-übergreifenden Analyse von Funksystemen gemäß einer Ausführungsform. Speziell zeigt Fig. 4 die Verarbeitungsschritte gemäß einer Ausführungsform, die durchgeführt werden, nachdem die Signaler-fassung durch die ein oder mehreren Antennen 210 bzw. 21S, 211 ... 21N und die ein oder mehreren Hochfrequenz-Baugruppen 220 bzw. 22S, 221, ..., 22N durchgeführt wurde.

Die in Fig. 4 dargestellten Module können in manchen Ausführungsformen durch ein oder mehrere Hardware-Bauelemente separat ohne die ein oder mehreren Hochfrequenz-Baugruppen 220 bzw. 21S, 221, ..., 22N realisiert sein.

In Fig. 4 überführt das Spektralanalysemodul 230 mittels Spektralanalyse das Empfangssignal abschnittsweise in den Spektralbereich. Das somit entstehende Spektrogramm wird mit einer Spektrogramm-Analyse z.B. durch einen Spektrogramm-Analysator 430 weiter untersucht.

Im Rahmen der Fig. 4 wird also zwischen Spektralanalyse und Spektrogramm-Analyse unterschieden. Mittels der Spektralanalyse wird ein Spektrogramm, z.B. durch Spektralanalysemodul 230 erzeugt. Die Spektrogramm-Analyse analysiert dagegen das erzeugte Spektrogramm, z.B. durch den Spektrogramm- Analysator 430.

Bei der Spektrogramm-Analyse werden zuerst beispielsweise die im Funkfrequenzspektrum enthaltenen Funksignale von Funkknoten und Störemissionen von anderen technischen Systemen detektiert.

Ebenso können bei der Spektrogramm-Analyse z.B. zeitliche, räumliche und spektrale Überlappungen von mehreren Funksignalen (sog. Paketkollision) sowie auch von Funksignalen mit Störemissionen detektiert werden.

Des Weiteren können z.B. die erkannten Funksignale nach bekannten Funkprotokollen klassifiziert werden (z.B. können die Funksignale als WiFi, Bluetooth, Bluetooth Low Energy, IEEE 802.15.4 oder als RFID Signale klassifiziert werden).

Des Weiteren können bei der Spektrogramm-Analyse die Funksignale untersucht und verschiedene Merkmalsidentifikatoren bestimmt werden (z.B. Empfangsleistung, Bandbreite, Schiefe der spektralen Leistungsverteilung, zeitliche Charakteristik), ihrer Abfolge analysiert und eine Mustererkennung durchgeführt werden.

Die erkannten Störemissionen können hinsichtlich ihrer spektralen Eigenschaften untersucht werden und daraus Cluster von Störemissionen abgeleitet werden. Diesen Clustern werden die erkannten Störemissionen zugeordnet.

Die Spektrogramm-Analyse (z.B. durch einen Spektrogramm-Analysator 430) gemäß bevorzugter Ausführungsbeispiele wird weiter unten näher dargestellt.

In Fig. 4 extrahieren die Demodulatoren 241, ..., 24N aus den empfangenen Funksignalen die Funkpakete ihres unterstützten Funkprotokolls. Jeder der Demodulatoren 241, ..., 24N kann dabei beispielsweise ein anderes Funkprotokoll unterstützen, als die anderen Demodulatoren 241, ..., 24N.

Jeder der Demodulatoren 241, ..., 24N leitet die demodulierten Paketinhalte mit Zusatzinformationen z.B. aus der Bitübertragungsschicht über den Empfang (z.B. Empfangsleistung der Pakete, Zeitpunkt des Empfangs, Modulations- und Codierungsverfahren des Funkpakets) sowie Konfigurationseinstellungen (z.B. eingestellte Empfangsfrequenz) an ein Vorverarbeitungsmodul 461, ..., 46N weiter. Jedes der Vorverarbeitungsmodule 461, .., 46N ist dafür ausgelegt, verschiedene Vorverarbeitungsschritte durchzuführen (z.B. eine Überprüfung oder eine Vervollständigung der Paketdaten / der Paketinhalte). Der Vorverarbeitungsblock ist jedoch optional. In anderen Ausführungsformen kann vorgesehen sei, alternativ die (Funk)paketdaten / Paketinformation einfach weiterzuleiten.

Die Ergebnisse der Spektrogramm-Analyse des Spektrogramm- Analysators 430 und die Ausgabe der Vorverarbeitungsmodule 461, ..., 46N werden in ein Synchronisationsmodul 470 eingespeist. In Ausführungsformen, die keine Vorverarbeitungsmodule 461, ..., 46N vorsehen, werden die Ausgaben der Demodulatoren 241, ..., 24N (die demodulierten Paketinhalte mit den Zusatzinformationen) direkt in das Synchronisationsmodul 470 eingespeist.

Das Synchronisationsmodul 470 führt einen Abgleich und eine Verknüpfung der empfangenen Funksignale der Spektrogramm-Analyse mit der Gesamtheit oder einer Auswahl der demodulierten Funkpakete durch. Der Abgleich kann mithilfe verschiedener Verfahren durchgeführt werden.

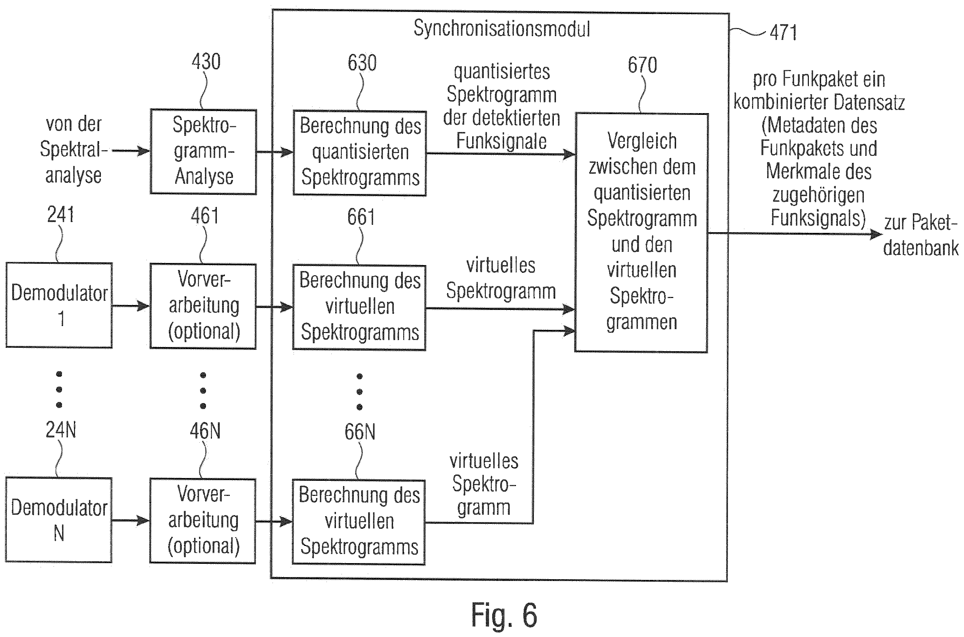

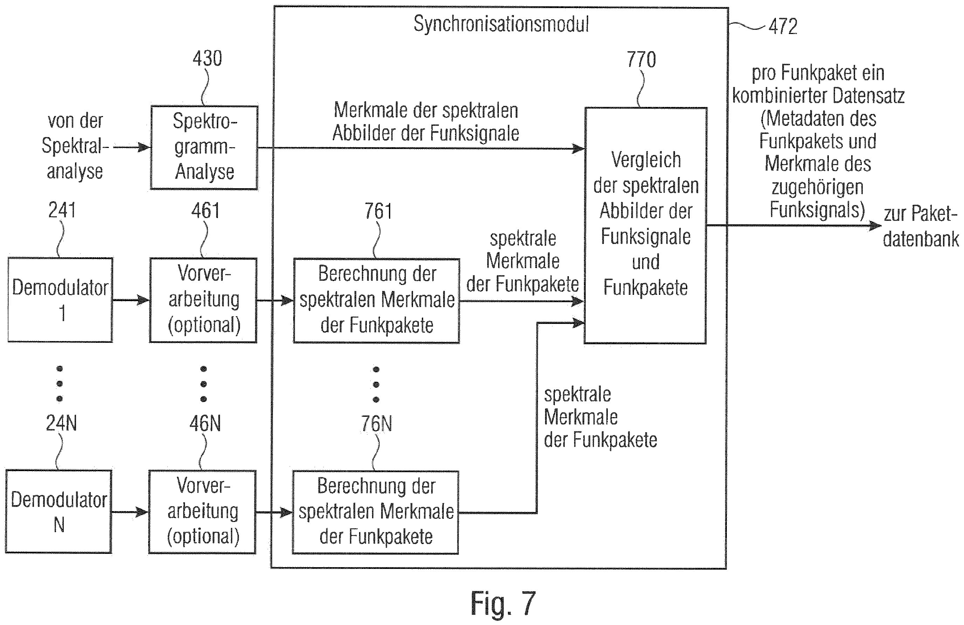

Unter Bezugnahme auf die Fig. 6 und Fig. 7 sind zwei verschiedene Ausführungsformen des Synchronisationsmoduls 470 beschrieben, bei denen der Abgleich im Spektralbereich durchführt wird. Hierfür werden zunächst aus den empfangenen Funkpaketen virtuelle Spektrogramme bzw. Merkmale der spektralen Abbilder der Funkpakete berechnet.

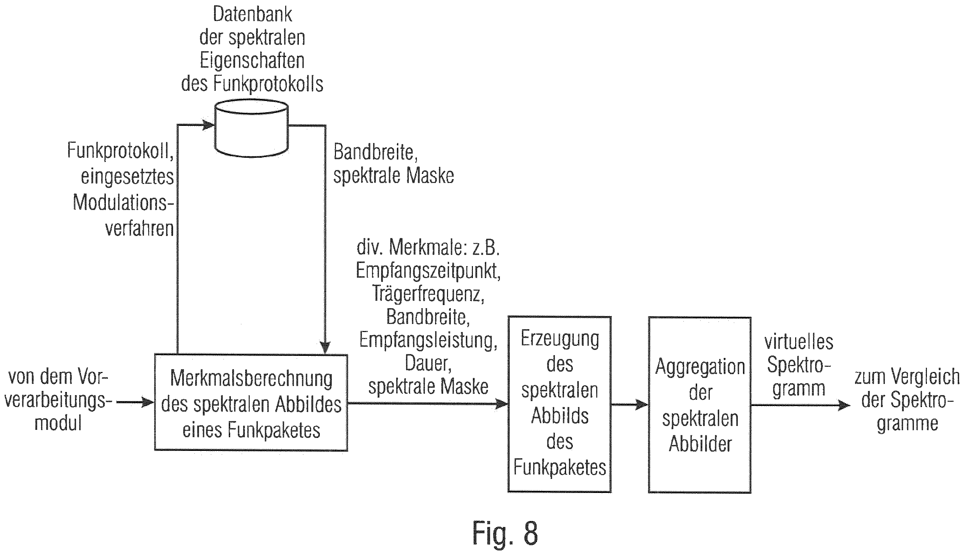

Unter Bezugname auf Fig. 8 wird dann ein bevorzugtes Ausführungsbeispiel zur Generierung eines virtuellen Spektrogramms aus den Daten der Funkpakete beschrieben. Der anschließende Abgleich kann auf Basis verschiedener Merkmale erfolgen (z.B. Empfangszeitpunkt, zeitlichen Länge, Empfangsleistung, Bandbreite und Abfolge der Funksignale).

Als Ergebnis dieses Abgleichs führt das Synchronisationsmodul 470 beispielsweise eine eineindeutige Verknüpfung der demodulierten Funkpakete mit den in der Spektrogramm-Analyse erkannten Funksignalen durch. Dies kann beispielsweise eine Zusammenführung der Informationen aus beiden Domänen (der Informationen aus der Spektralanalyse und der Informationen aus der Demodulation) in je einem Datensatz pro Funkpaket sein.

Im Fall von erkannten zeitlichen, räumlichen und spektralen Überlagerungen von Funksignalen (sog. Paketkollisionen) können beispielsweise die Datensätze der betroffenen demodulierten Funkpakete miteinander verknüpft werden.

Pro Funksignal wird somit ein Datensatz generiert. Jeder Datensatz enthält jeweils mehreren Teilen. Ein Teil dient zur Abspeicherung der Merkmale des spektralen Abbildes, die in der Spektrogramm-Analyse berechnet wurden. Ein weiterer Teil dient zur Abspeicherung von Merkmalen und Inhalten des zugehörigen Funkpaketes. Falls das Funkpaket nicht demoduliert werden konnte, kann in Ausführungsformen dieser Teil entfallen oder leer bleiben. Ein weiterer Teil kann zur Abspeicherung von Verknüpfungen zwischen Datensätzen genutzt werden, z.B. zur Repräsentation einer Paketkollision. Diese Verknüpfung kann aber auch auf andere Weise abgespeichert werden

In Ausführungsformen kann das Synchronisationsmodul 470 die generierten Datensätze an eine oder verschiedene Datenbanken 480 (nachfolgend Paketdatenbank genannt) zur (Zwischen)speicherung übergeben. Alternativ kann auch auf die Zwischenspeicherung verzichtet werden und die Datensätze direkt an nachfolgende Baugruppen weitergeleitet werden.

In Ausführungsformen, in denen separate Hardwarekomponenten für die Spektralanalyse und die Demodulation der Funkpakete genutzt werden, können spezifische Zeitversätze den Ergebnisdaten der Hardwarekomponenten (d.h. dem Spektrogramm und den demodulierten Funkpaketen) auftreten. In diesem Fall kann das Synchronisationsmodul 470 diese Zeitversätze schätzen. Dafür ist es wünschenswert, dass die von den Demodulatoren ermittelten Empfangszeitpunkte der Funkpakete einen tolerierbaren kleinen Jitter durch die Verarbeitungskette aufweisen. Ggf. treten auch größere Jitterwerte auf. Dann kann beispielsweise in manchen Ausführungsformen das Synchronisationsmodul 470 durch Analyse der Abfolge, zeitliche Länge und Bandbreite der Funkpakete die Verknüpfungen der im Spektrogramm erkannten Funkpaketen mit demodulierten Funkpaketen durchführen.

In Ausführungsformen kann die Ermittlung der spezifischen Zeitversätze basierend auf dem Vergleich zwischen den Empfangszeitpunkten der demodulierten Funkpakete und den Ergebnissen der Spektrogramm-Analyse durchgeführt werden. Daraus können statische Zeitversätze als auch zeitlich veränderliche Zeitversätze zwischen den Funk-Hardwarekomponenten geschätzt werden. Diese können anschließend genutzt werden, um die in dem Vergleich der beiden Domänen genutzten Suchfenster besser eingrenzen zu können und somit die Rechenkomplexität des Abgleichs zu reduzieren.

In Ausführungsformen kann ein Nachverarbeitungsmodul 490 vorgesehen sein, das ausgelegt ist, weitere Analysen durchzuführen. Diese weiteren Analysen können auf Basis der Datensätze in der Paketdatenbank durchgeführt werden, wobei weitere Verarbeitungsschritte durchgeführt werden, die zusätzliche Informationen generieren. Diese zusätzlichen Information können beispielsweise den Datensätzen hinzugefügt werden, die in der Datenbank 480 abgespeichert sind, oder können auf andere Weise abgespeichert werden. Beispielsweise können aus dem Inhalt der Funkpakete, Informationen aus höheren Protokollschichten analysiert, Metadaten extrahiert und abgespeichert werden.

Zudem kann es aus Performance-Gründen vorteilhaft sein, einen Teil der oben genannten Analysen nicht vor Abspeicherung in der Paketdatenbank 480 durchzuführen, sondern erst nachträglich durchzuführen. So kann das Nachverarbeitungsmodul 490 ausgelegt sein, beispielsweise eine Kollisionsdetektion, eine Klassifikation und Mustererkennung der Spektrogramm-Analyse oder eine Datenanalyse der demodulierten Funkpakete als Nachverarbeitungsschritte durchzuführen. In anderen Ausführungsformen kann jedoch vorgesehen sein, einen Teil dieser Nachverarbeitungsschritte bereits vor der Einspeisung der Datensätze in die Paketdatenbank 480 durchzuführen.

Ausführungsformen basieren auf der Idee, aus der Gewinnung von Informationen aus mehreren Quellen, insbesondere der Spektrogramm-Analyse und Multi-Protokollanalyse, und der Verknüpfung dieser Informationen, neue Erkenntnisse zu ermitteln.

Insbesondere kann vorgesehen sein, die Funkverbindungen beispielsweise in verschiedenen Ebenen separat zu analysieren, z.B. in der Spektralebene, oder z.B. in der Bitsicherungsschicht, oder in einer oder mehrerer der OSI-Schichten 2 bis 7.

In der Bitsicherungsschicht kann beispielsweise der Empfangszeitpunkt, die zeitliche Länge des Funkpakets oder die Empfangsleistung oder der Frequenzkanal oder die Korrektheit des Empfangs oder die Modulationsart analysiert werden.

In einer der OSI Schichten 2 bis 7 können z.B. die Paketinhalte oder die Sende-Funkknoten oder die Empfangs-Funkknoten oder der Pakettyp analysiert werden.

Des Weiteren kann in Ausführungsformen vorgesehen sein, das Funkfrequenzspektrum automatisch zu analysieren. Dies kann dazu dienen, Funksignale im Spektrogramm zu erkennen, und/oder Funksignale nach Funkprotokollen zu klassifizieren, und/oder Anomalien in dem Abbild der Funksignale in dem Funkfrequenzspektrum zu erkennen, und/oder zeitliche, räumliche und spektrale Überlagerungen mehrerer Funksignale oder Funksignale mit Störemissionen zu detektieren.

In Ausführungsformen werden die Ergebnisse der Spektrogramm-Analyse mit den demodulierten Funkpaketen und deren Paketinhalten verknüpft.

Im Fall von Paketkollisionen werden die betroffenen demodulierten Funkpakete miteinander verknüpft.

Nachfolgend wird die Spektrogramm-Analyse gemäß bevorzugten Ausführungsbeispielen beschrieben. Die Analyse des Spektrogramms dient beispielsweise der Erkennung von Funksignalen im Spektrogramm und/oder der Klassifikation nach Funkprotokollen der Erkennung von Mustern in der Abfolge der Funksignale, und/oder der Erkennung von Anomalien in dem Abbild der Funksignale in dem Funkfrequenzspektrum, und/oder der Detektion von zeitlichen und spektralen Überlagerungen mehrerer Funksignale oder von Funksignalen mit Störemissionen.

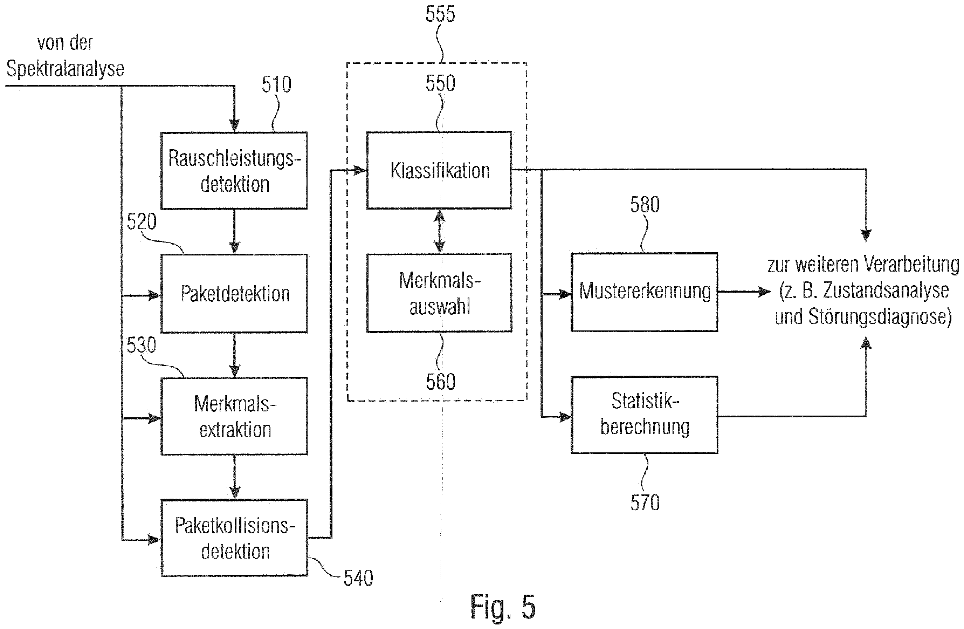

Fig. 5 zeigt einen Spektrogramm-Analysator 430 zur automatischen Spektrogramm-Analyse gemäß einer beispielhaften Ausführungsform.

Die vorgelagerte Spektralanalyse, z.B. durch das Spektralanalysemodul 230, berech-net/bestimmt aus dem Empfangssignal abschnittsweise das Frequenzspektrum.

In dem speziellen Ausführungsbeispiel der Fig. 5 wird das Frequenzspektrum dann beispielsweise in einer Kaskade von 5 Analyseblöcken (Rauschleistungsdetektor 510, Paketdetektor 520, Merkmalsextraktor 530, Paketkollisionsdetektor 540 und Klassifikator 550) weiterverarbeitet.

In Ausführungsformen kann beispielsweise jeder Analyseblock dabei jeweils auch die Ergebnisse des jeweils vorherigen Analyseblocks nutzen und/oder ergänzen.

Der Rauschleistungsdetektor 510 kann ausgelegt sein, die Rauschleistung im dem Spektrogramm zu schätzen.

Der Paketdetektor 520 kann zur Detektion von Funksignalen im Spektrogramm ausgelegt sein.

Der Merkmalsextraktor 530 kann ausgelegt sein, für jedes erkannte Funksignal verschiedene Merkmale aus dem Frequenzspektrum zu extrahieren, wie beispielsweise Empfangszeitpunkt und/oder Leistungsparameter und/oder Leistungsdichtespektrum und/oder Frequenzcharakteristiken. Diese Merkmale geben Aufschluss darüber ob eine Kollision von Funksignalen vorliegt.

Der Paketkollisionsdetektor 540 kann ausgebildet sein, im Verdachtsfall einer Paketkolli-sion den betreffenden Teil des Frequenzspektrums zu untersuchen.

In Fig. 5 umfasst eine Zuordnungseinheit 555 den Klassifikator 550 und eine Merkmalsauswahleinheit 560.

Der Klassifikator 550 kann ausgelegt sein, die erkannten Funksignale nach bekannten Funkprotokollen zu klassifizieren.

Des Weiteren kann die Merkmalsauswahl-Einheit 560 beispielsweise, falls die Funksignale keinem bisher bekannten Funkprotokoll zugeordnet werden können, die signifikanten Merkmale des spektralen Abbildes der Funksignale auswählen.

Ferner kann der Klassifikator 550 beispielsweise Konzepte des maschinellen Lernens (z.B. der künstliche Intelligenz) eingesetzt werden, um das spektrale Erscheinungsbild von bisher noch nicht bekannten Funkprotokollen zu erlernen, so dass auch Funksignale dieses Funkprotokolls klassifiziert werden können. Beispielsweise können hierzu neuronale Netze eingesetzt werden.

Die Zuordnungseinheit 555 ist zur Zuordnung von ein oder mehreren Eigenschaften zu jedem der zwei oder mehreren aufgefundenen Funkpakete basierend auf dem Spektrogramm in der Zeit-Frequenz Domäne ausgelegt. Diese Funktionalität kann in dem Klassifikator 550, in der Merkmalsauswahleinheit 560, in beiden Einheiten gemeinsam, oder in einem in Fig. 5 nicht gezeigten Zuordnungssubmodul realisiert sein. Bei den ein oder mehreren Eigenschaften der zwei oder mehreren aufgefundenen Funkpakete kann es sich beispielsweise um einen Empfangszeitpunkt eines aufgefundenen Funkpakets, eine Trägerfrequenz, eine Bandbreite, eine Empfangsleistung, eine zeitliche Dauer des Funkpakets und/oder ein Leistungsdichtespektrum des Funkpakets handeln.

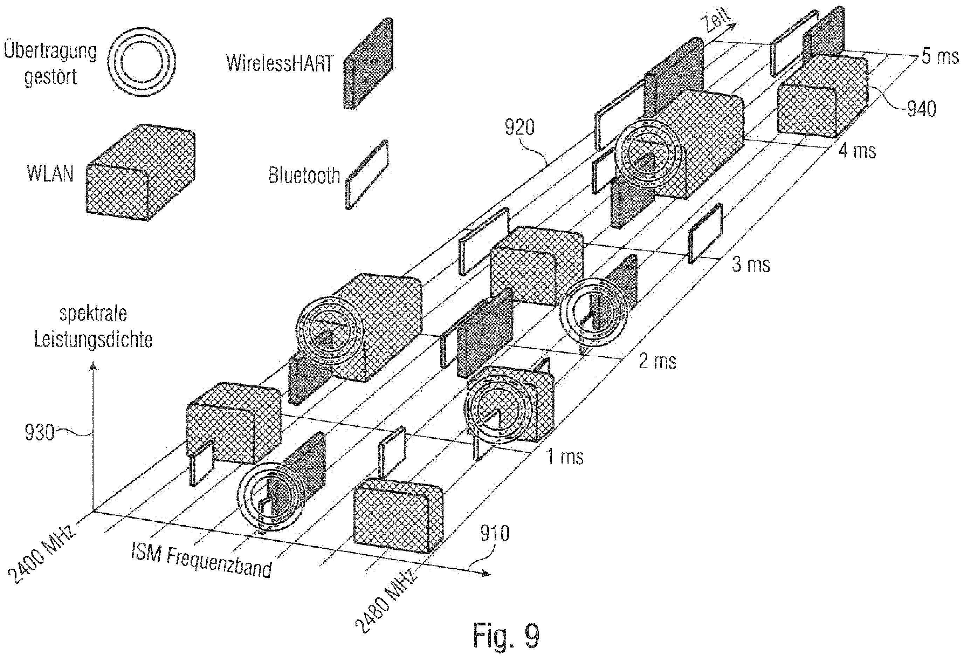

Fig. 9 zeigt ein Spektrogramm in der Zeit-Frequenz Domäne, in der eine Vielzahl von Funkpaketen dargestellt sind. Koordinatenachse 910 ist die Frequenzachse. Koordinatenachse 920 ist die Zeitachse. Koordinatenachse 930 ist eine Achse, die eine spektrale Leistungsdichte angibt. Liegt in einem Bereich der Zeit-Frequenz Domäne ein Funkpaket vor, so ist der Wert der spektralen Leistungsdichte größer Null, etwa im Bereich des Funkpakets 940 im Spektrogramm in der Zeit-Frequenz Domäne.

Weiter oben wurde dargestellt, dass der Rauschleistungsdetektor 510 ausgelegt sein kann, die Rauschleistung im dem Spektrogramm zu schätzen.

Der Rauschleistungsdetektor 510 kann dann ausgelegt sein, Leistungswerte oder Leistungsdichtewerte im Spektrogramm, die kleiner oder gleich einem Grenzwert sind, der von der Rauschleistung abhängt, im Spektrogramm auf den Wert Null zu setzen. Der Paketde-tektor 520 kann dann ausgelegt sein, Bereiche in der Zeit-Frequenz Domäne, in denen die Leistungswerte oder die Leistungsdichtewerte gleich Null sind, als Bereiche in der Zeit-Frequenz Domäne zu bestimmen, in denen kein Funkpaket vorliegt. Ferner kann der Paketdetektor 520 dann ausgelegt sein, Bereiche in der Zeit-Frequenz Domäne, die Leistungswerte oder die Leistungsdichtewerte größer Null aufweisen, als Bereiche in der Zeit-Frequenz Domäne zu bestimmen, in denen ein Funkpaket vorliegt.

Alternativ kann der Paketdetektor 520 ausgelegt sein, die Leistungswerte oder die Leistungsdichtewerte im Spektrogramm, die kleiner oder gleich dem Grenzwert sind, der von der Rauschleistung abhängt, im Spektrogramm als Bereiche in der Zeit-Frequenz Domäne zu bestimmen, in denen kein Funkpaket vorliegt. Ferner kann der Paketdetektor 520 dann ausgelegt sein, Bereiche in der Zeit-Frequenz Domäne, die Leistungswerte oder die Leistungsdichtewerte größer dem Grenzwert aufweisen, als Bereiche in der Zeit-Frequenz Domäne zu bestimmen, in denen ein Funkpaket vorliegt.

In Fig. 5 kann ein Statistikmodul 570 auf Basis der Ergebnisse der Klassifikation durch den Klassifikator 550 beispielsweise verschiedene statistische Berechnungen für jedes erkannte Funkprotokoll durchführen. Beispielsweise kann das Statistikmodul ausgelegt sein, eine Kanalbelegung und/oder eine Empfangsleistung und/oder eine Paketlänge zu berechnen.

Des Weiteren kann ein Mustererkennungsmodul 580 dafür ausgelegt sein, beispielsweise die Abfolge der Funksignale jedes Funkprotokolls zu untersuchen und auf der Abfolge der Funksignale Mustererkennung durchzuführen.

Im Folgenden wird der Abgleich der Daten der Spektrogramm-Analyse mit den demodulierten Funkpaketen gemäß einer ersten Gruppe bevorzugter Ausführungsformen unter Bezugnahme auf Fig. 6 beschrieben.

In einer Ausführungsform ist der Paketkollisionsdetektor 540 ausgebildet, für jedes der zwei oder mehreren aufgefundenen Funkpakete basierend auf dem Spektrogramm in der Zeit-Frequenz Domäne festzustellen, ob es für dieses aufgefundene Funkpaket zu einer Kollision mit einem anderen der zwei oder mehreren aufgefundenen Funkpakete gekommen ist.

Die Zuordnungseinheit 555 ist ausgebildet, diesem aufgefundenen Funkpaket als eine der ein oder mehreren Eigenschaften die Information zuzuordnen, dass es zu einer Kollision mit einem anderen der zwei oder mehreren aufgefundenen Funkpakete gekommen ist,

Ferner ist das Synchronisationsmodul 170; 470; 471; 472 ausgebildet, ein Paar der ein oder mehreren Paare so zu bestimmen, dass das genau eine demodulierte Funkpaket dieses Paares dasjenige Funkpaket ist, das dem im Spektrogramm aufgefundenen Funkpaket entspricht, bei dem es zu einer Kollision mit einem anderen Funkpaket gekommen ist, und dass eine der ein oder mehreren Eigenschaften des Paares die Information ist, dass es bei dem demodulierten Funkpaket dieses Paares zu einer Kollision gekommen ist,

Des Weiteren ist das Synchronisationsmodul 170; 470; 471; 472 ausgebildet, die Information auszugeben, dass es bei dem demodulierten Funkpaket dieses Paares zu einer Kollision gekommen ist.

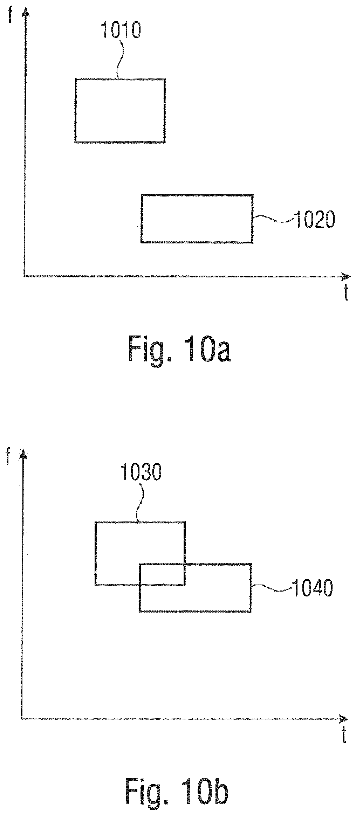

Fig. 10a und Fig. 10b erläutern dies. Fig. 10a und 10b zeigen eine zweidimensionale Darstellung des Spektrogramms, wobei die t-Achse die Zeit und wobei die f-Achse die Frequenz bezeichnet.

In Fig. 10a sind ein erstes Funkpaket 1010 und ein zweites Funkpaket 1020 in der Zeit-Frequenz Domäne überschneidungsfrei. Beide Funkpakete 1010 und 1020 kollidieren also nicht.

In Fig. 10b ein drittes Funkpaket 1030 und ein viertes Funkpaket 1040 in der Zeit-Frequenz Domäne nicht überschneidungsfrei. Beide Funkpakete 1030 und 1040 kollidieren also.

In einer Ausführungsform ist also vorgesehen, dass der Paketkollisionsdetektor 540 ausgebildet ist, für zwei Funkpakete der zwei oder mehreren aufgefundenen Funkpakete festzustellen, ob diese Funkpakete miteinander kollidieren, indem der Paketkollisionsdetektor 540 in der Zeit-Frequenz Domäne des Spektrogramms feststellt, ob diese zwei Funkpakete überschneidungsfrei sind oder nicht.

In einer weiteren Ausführungsform ist der Merkmalsextraktor 530 ausgebildet, für jedes der zwei oder mehreren aufgefundenen Funkpakete basierend auf dem Spektrogramm in der Zeit-Frequenz Domäne festzustellen, ob dieses aufgefundene Funkpaket eine Störung im Spektrogramm aufweist.

Die Zuordnungseinheit 555 ist ausgebildet, diesem aufgefundenen Funkpaket als eine der ein oder mehreren Eigenschaften die Information zuzuordnen, dass dieses aufgefundene Funkpaket eine Störung im Spektrogramm aufweist.

Ferner ist das Synchronisationsmodul 170; 470; 471; 472 ausgebildet, ein Paar der ein oder mehreren Paare so zu bestimmen, dass das genau eine demodulierte Funkpaket dieses Paares dasjenige Funkpaket ist, das dem im Spektrogramm aufgefundenen Funkpaket entspricht, das eine Störung im Spektrogramm aufweist, und dass eine der ein oder mehreren Eigenschaften des Paares die Information ist, dass das demodulierten Funkpaket dieses Paares unter Auftreten einer Störung übertragen wurde. Störungen können beispielsweise durch Hardware-Defekte der HF-Baugruppe des aussendenden Funkknotens verursacht worden sein.

Des Weiteren ist das Synchronisationsmodul 170; 470; 471; 472 ausgebildet, die Information auszugeben, dass das demodulierten Funkpaket dieses Paares unter Auftreten einer Störung übertragen wurde.

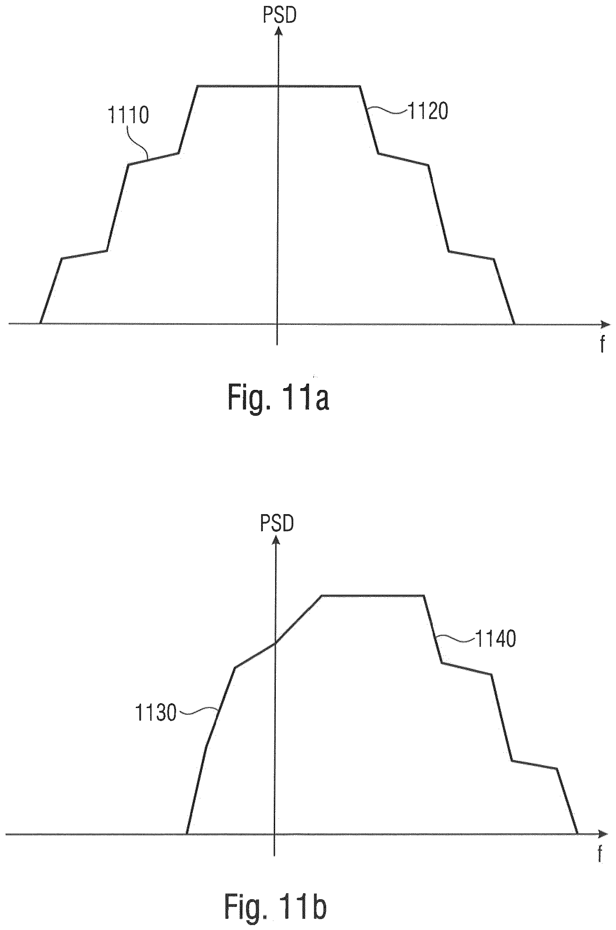

Fig. 11a und 11b erläutern dies. Fig. 11a und 11b zeigen eine zweidimensionale Darstellung des Spektrogramms für ein Funkpaket, wobei die f-Achse die Frequenz und wobei die PSD-Achse die Leistungsdichte bezeichnet (PSD = Power Spectral Density; deutsch: Leistungsdichtespektrum).

Konkret zu sehen in Fig. 11a ist ein Leistungsdichtespektrum eines Funkpakets. In Fig. 11a ist das Leistungsdichtespektrum des Funkpakets symmetrisch. Konkret sind der niederfrequente Teil 1110 des Leistungsdichtespektrums und der höherfrequente Teil 1120 des Leistungsdichtespektrums symmetrisch.

In Fig. 11b ist das Leistungsdichtespektrum des Funkpakets jedoch unsymmetrisch. Konkret sind der niederfrequente Teil 1130 des Leistungsdichtespektrums und der höherfrequente Teil 1140 des Leistungsdichtespektrums unsymmetrisch. Es kann aufgrund der fehlenden Symmetrie des Leistungsdichtespektrums des Datenpakets auf das Auftreten einer Störung geschlossen werden.

Somit kann der Merkmalsextraktor 530 also beispielsweise ausgebildet sein, für ein Funkpaket der zwei oder mehreren aufgefundenen Funkpakete basierend auf dem Spektrogramm in der Zeit-Frequenz Domäne festzustellen, ob dieses aufgefundene Funkpaket eine Störung im Spektrogramm aufweist, indem der Merkmalsextraktor 530 ermittelt, ob ein Leistungsdichtespektrum des Funkpakets in einer Frequenz-Leistungsdichte Domäne des Spektrogramms eine Asymmetrie aufweist. (Beispielsweise eine unsymmetrische Abweichung von einer in einen Spezifikationsdokument eines Funkprotokolls spezifizierten spektralen Maske).

Statt das Leistungsdichtespektrum auf Symmetrien zu untersuchen, kann alternativ eine vordefinierte, korrekte spektrale Maske aus einer Datenbank geladen werden, und mit dem tatsächlichen Leistungsdichtespektrum auf Übereinstimmung geprüft werden. Unter einer spektralen Maske kann dabei z.B. ein vordefiniertes oder gespeichertes Leistungsdichtespektrum eines (idealen oder idealisierten) Funkpakets verstanden werden. Bei fehlender Übereinstimmung der vordefinierten, korrekten spektrale Maske mit dem tatsächlichen Leistungsdichtespektrum des Funkpakets im Spektrogramm kann auf eine Störung geschlossen werden.

Der Merkmalsextraktor 530 kann also beispielsweise ausgebildet sein, für ein Funkpaket der zwei oder mehreren aufgefundenen Funkpakete basierend auf dem Spektrogramm in der Zeit-Frequenz Domäne festzustellen, ob dieses aufgefundene Funkpaket eine Störung im Spektrogramm aufweist, indem der Merkmalsextraktor 530 ein tatsächliches Leistungsdichtespektrum des Funkpakets in einer Frequenz-Leistungsdichte Domäne mit einer vordefinierten spektralen Maske vergleicht.

Beispielsweise kann der Merkmalsextraktor 530 ausgebildet sein, die vordefinierte spektrale Maske aus einer Datenbank in Abhängigkeit von einem Funkprotokoll des aufgefundenen Funkpakets zu laden. So sind spektrale Masken unterschiedlicher Funkprotokolle in der Regel unterschiedlich.

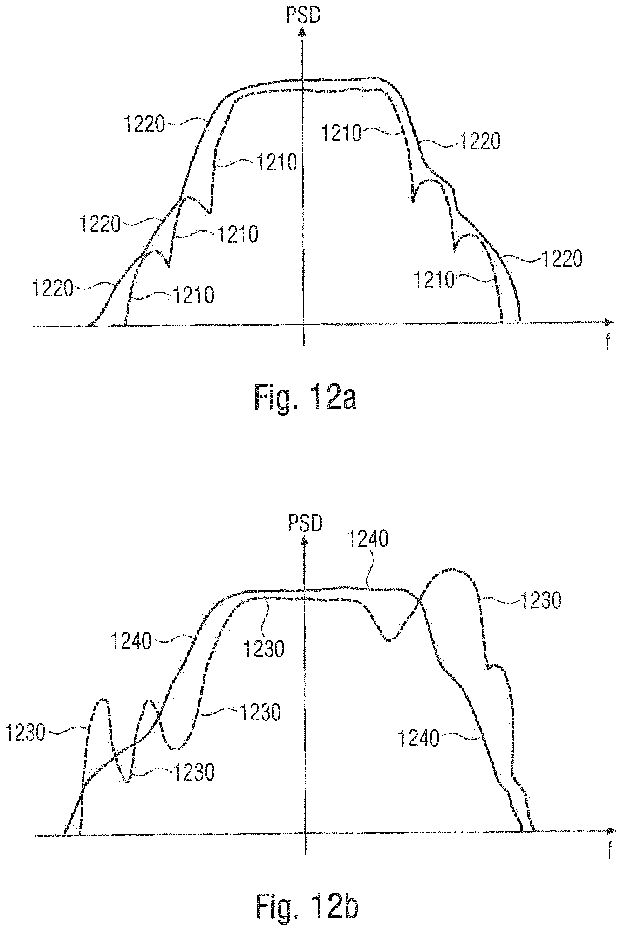

Fig. 12a vergleicht ein erstes tatsächliches Leistungsdichtespektrum 1210 mit einer ersten spektralen Maske 1220, wobei das erste tatsächliche Leistungsdichtespektrum 1210 der ersten vordefinierten spektralen Maske 1220 entspricht: Das erste tatsächliche Leistungsdichtespektrum 1210 bleibt immer unterhalb der ersten vordefinierten spektralen Maske 1220, was hier z.B. anzeigt, dass das erste tatsächliche Leistungsdichtespektrum 1210 der ersten spektralen Maske 1220 entspricht. Es liegt also vermutlich keine Störung vor.

Fig. 12b vergleicht ein zweites tatsächliches Leistungsdichtespektrum 1230 mit einer zweiten spektralen Maske 1240, wobei das zweite tatsächliche Leistungsdichtespektrum 1230 der zweiten vordefinierten spektralen Maske 1240 nicht entspricht: Das zweite tatsächliche Leistungsdichtespektrum 1230 ist teilweise größer als die zweite vordefinierte spektrale Maske 1240, was hier z.B. anzeigt, dass das zweite tatsächliche Leistungsdichtespektrum 1230 der zweiten spektralen Maske 1240 nicht entspricht. Es liegt also vermutlich eine Störung vor.

Fig. 6 zeigt ein Synchronisationsmodul 471 zum Abgleich der Daten der Spektrogramm-Analyse mit den demodulierten Funkpaketen gemäß einer ersten Gruppe bevorzugter Ausführungsformen. In Fig. 6 sind der Spektrogramm-Analysator 430, die Demodulatoren 241,..., 24N und die Vorverarbeitungsmodule 461, ..., 46N dem Synchronisationsmodul 471 vorgeschaltet; die Vorverarbeitungsmodule 461, ..., 46N sind optional.

Das Synchronisationsmodul 471 der Fig. 6 ist zum Abgleich der Ergebnisdaten der Spektrogramm-Analyse und mit den Metadaten der demodulierten Funkpakete ausgelegt.

In Fig. 6 sind eine oder mehrere Virtuelles-Spektrogramm-Berechnungseinheiten 661, ..., 66N dafür ausgelegt, aus den Informationen der demodulierten Funkpakete je Demodulator 241, ..., 24N, ein virtuelles Spektrogramm der zugehörigen Funksignale zu berechnen. Unter Bezugnahme auf Fig. 8 unten ist ein mögliches Verfahren zur Erzeugung des virtuellen Spektrogramms vorgestellt.

Eine Quantisiertes-Spektrogramm-Berechnungseinheit 630 ist dafür ausgebildet, aus den Ergebnissen der Spektrogramm-Analyse in gleicher Weise wie bei der Erzeugung der virtuellen Spektrogramme durch die Virtuelles-Spektrogramm-Berechnungseinheiten 661, ..., 66N für jedes erkannte Funkpaket ein spektrales Abbild zu bilden. Dazu ist die Quantisiertes-Spektrogramm-Berechnungseinheit 630 ausgebildet, aus einer Überlagerung der spektralen Abbilder der Funksignale ein quantisiertes Abbild des Spektrogramms zu berechnen Unter einem spektralen Abbild eines Funkpakets kann man beispielsweise das Spektrogramm des Funkpakets in der Zeit-Frequenz Domäne verstehen.

Eine Vergleichseinheit 670 ist ausgebildet, jeweils das quantisierte Spektrogramm abschnittsweise mit dem virtuellen Spektrogramm eines Demodulators 241, ..., 24N zu vergleichen und einen Abgleich auf Funkpaket-Ebene durchzuführen. In verschiedenen Ausführungsformen können hierzu verschiedene Konzepte eingesetzt werden.

Beispielsweise können die Spektrogramme in spektrale Bereiche unterteilt werden. Anschließend können die äquivalenten Bereiche jedes virtuellen Spektrogramms mit denen des quantisierten Spektrogramms durch eine Korrelation zeitlich variabler Abschnitte verglichen werden. Im Ergebnis werden die demodulierten Funkpakete mit ihren Pendants in den spektralen Abbildern der Funksignale (den Ergebnissen der Spektrogramm-Analyse) verknüpft und in einen gemeinsamen Datensatz übertragen.

Zusätzlich kann der Versatz zwischen den Empfangszeitpunkten der in der Spektrogramm-Analyse detektierten Funksignale und der demodulierten Funkpakete ermittelt werden. Falls separate Hardwarekomponenten für die Spektralanalyse und die Demodulation der Funkpakete genutzt wurden, kann durch die statistische Analyse der oben angesprochenen Zeitunterschiede (der Versatz zwischen den Empfangszeitpunkten) auf den zeitlichen Versatz zwischen der Spektralanalyse und den Demodulatoren zurückgeschlossen werden.

In Ausführungsformen kann das Synchronisationsmodul 471 also ausgebildet sein, ein quantisiertes Spektrogramm basierend auf den ein oder mehreren Eigenschaften eines in dem Spektrogramm aufgefundenen Funkpakets der zwei oder mehreren aufgefundenen Funkpakete zu berechnen. Dabei kann das Synchronisationsmodul 471 ausgebildet sein, ein virtuelles Spektrogramm basierend auf den Zusatzinformationen zu einem der zwei oder mehreren demodulierten Funkpakete zu berechnen. Ferner kann das Synchronisationsmodul 471 ausgebildet sein, das quantisierte Spektrogramm und das virtuelle Spektrogramm miteinander zu vergleichen, um festzustellen, ob dieses in dem Spektrogramm aufgefundene Funkpakets diesem demodulierten Funkpaket entspricht.

Im Folgenden wird der Abgleich der Daten der Spektrogramm-Analyse mit den demodulierten Funkpaketen gemäß einer zweiten Gruppe bevorzugter Ausführungsformen unter Bezugnahme auf Fig. 7 beschrieben.

Fig. 7 zeigt ein Synchronisationsmodul 472 zum Abgleich der Daten der Spektrogramm-Analyse mit den demodulierten Funkpaketen gemäß einer zweiten Gruppe bevorzugter Ausführungsformen. In Fig. 7 sind der Spektrogramm-Analysator 430, die Demodulatoren 241,..., 24N und die Vorverarbeitungsmodule 461, ..., 46N dem Synchronisationsmodul 472 vorgeschaltet; die Vorverarbeitungsmodule 461, ..., 46N sind optional.

Die Ausführungsbeispiele nach Fig. 7 ähneln in ihrer Grundstruktur den Ausführungsbeispielen, die unter Bezugnahme auf Fig. 6 beschrieben wurden. Einer der Unterschiede liegt im Vergleich zu Fig. 6 liegt bei den Ausführungsbeispielen der Fig. 7 darin, dass für den Vergleich der Daten der Spektrogramm-Analyse und den Daten der demodulierten Funkpakete nur die Merkmale der spektralen Abbilder der Funksignale bzw. Funkpakete genutzt werden, statt ein quantisiertes Spektrogramm und virtuelle Spektrogramme zu erzeugen. Damit ergibt sich für Fig. 7 eine deutliche Vereinfachung der rechentechnischen Komplexität. Zur Berechnung der spektralen Merkmale der Funkpakete können in den Ausführungsbeispielen der Fig. 7 Spektralmerkmals-Ermittlungseinheiten 761, ..., 76N vorgesehen sein.

Die von der Spektrogramm-Analyse generierten spektralen Merkmale der detektierten Funksignale werden direkt in die Vergleichseinheit 770 eingespeist. Aus den Daten jedes demodulierten Funkpaketes werden die Merkmale des zugehörigen spektralen Abbildes berechnet und ebenfalls dem Vergleichsmodul zugeführt. Diese Berechnung der Merkmale des zugehörigen spektralen Abbildes erfolgt in der gleichen Weise weiter unten unter Bezugnahme auf Fig. 8 beschrieben.

Die Vergleichseinheit 770 separiert die erhaltenen Funksignale und Funkpakete unter Beachtung ihrer Abfolge nach Trägerfrequenz und Bandbreite. Beispielsweise untersucht die Vergleichseinheit 770 in jeder Gruppe (d.h. Trägerfrequenz-Bandbreite Kombination) nun die Abfolge der Funksignale bzw. Funkpakete, beispielsweise nach Ähnlichkeiten hinsichtlich Paketdauer, Empfangsleistung, Abfolge. Beispielsweise können hierfür Verfahren wie die Lewenstein-Distanz, Fuzzy Hashing oder Piecewise Hashing eingesetzt werden. Im Ergebnis ermittelt der Vergleichsblock Ähnlichkeiten zwischen den Funksignalen und den Funkpaketen und verknüpft diese in gleicher Weise, wie für die Ausführungsbeispiele der Fig. 6 beschrieben.

In Ausführungsformen kann das Synchronisationsmodul 472 also ausgebildet sein, mindestens eine Eigenschaft der ein oder mehreren Eigenschaften eines in dem Spektrogramm aufgefundenen Funkpakets der zwei oder mehreren aufgefundenen Funkpakete mit einer Information aus den Zusatzinformationen eines demodulierten Funkpakets der zwei oder mehreren demodulierten Funkpakete miteinander zu vergleichen, um festzustellen, ob dieses in dem Spektrogramm aufgefundene Funkpakets diesem demodulierten Funkpaket entspricht.

Im Folgenden wird die Berechnung eines virtuellen Spektrogramms gemäß bevorzugter Ausführungsbeispiele unter Bezugnahme auf Fig. 8 beschrieben.

Fig. 8 zeigt ein Blockschaltdiagramm zur Berechnung des virtuellen Spektrogramms der demodulierten Funkpakete gemäß einem Ausführungsbeispiel. Die Virtuelles-Spektrogramm-Berechnungseinheiten 661, ..., 66N der Fig. 6 können dabei ausgebildet sein, die Berechnung des virtuellen Spektrogramms gemäß Fig. 8 zu implementieren.

Gemäß Fig. 8, können im ersten Schritt für jedes demodulierte Funkpaket aus dessen Inhalt, den Zusatzinformationen der Bitübertragungsschicht und den Konfigurationsdaten des Demodulators (eines der Demodulatoren 241, ..., 24N) verschiedene Merkmale seines spektralen Abbildes berechnet werden.

Die Bandbreite und die spektrale Maske des spektralen Abbildes werden aus dem Funkprotokoll und dem eingesetzten Modulations- und Codierungsverfahren des Funkpaketes berechnet. Hierfür kann auch die Abfrage einer entsprechenden Datenbank genutzt werden. Somit können fehlende Merkmale des spektralen Abbildes des Funkpaketes (z.B. Paketdauer, Bandbreite) berechnet werden und dem Datensatz des demodulierten Funkpaketes hinzugefügt werden.

Anschließend werden aus den spektralen Merkmalen (z.B. Empfangszeitpunkt, Paketdauer, Empfangsleistung, Mittenfrequenz, Bandbreite, spektrale Maske) jedes Funkpaketes sein spektrales Abbild generiert. Durch die Aggregation der spektralen Abbilder der Funksignale des jeweiligen Demodulators wird ein virtuelles Spektrogramm berechnet.

Ausführungsformen der Erfindung realisieren eine Kombination der Informationen der demodulierten Funkpakete mit Informationen aus der Spektrogramm-Analyse. Durch die Kombination der Informationen aus den zwei Domänen (Spektralbereich und Funkpaketinhalt) wird die Datenbasis für nachfolgende Analysen verbessert und erweitert, z.B. der Analyse des Zustandes der Funkverbindungen oder der Ursachendiagnose im Fall von Störungen. Dies führt zu einer signifikant höheren Schätzgüte und Schätzgenauigkeit der nachfolgenden Analysen. Diese führt beispielsweise bei der Ursachendiagnose zu einer Reduzierung der Fehler erster und zweiter Art.

Des Weiteren ermöglichen Ausführungsformen eine Detektion von zeitlichen, räumlichen und spektralen Überlappungen zwischen benachbarten Funksystemen oder Funkverbindungen. Durch die Verknüpfung der Ergebnisse der Spektrogramm-Analyse mit der Daten der demodulierten Funkpakete können Paketkollisionen erkannt und die jeweils betroffenen Funkpakete verknüpft werden. Dies gibt nachfolgenden Analysen konkrete Hinweise über die mögliche Ursache-Wirkungsbeziehung zwischen den betroffenen Funkverbindungen. Dies unterstützt beispielsweise die Zustandsanalyse und Ursachendiagnose, verbessert ihre Schätzgüte. In einigen Szenarien wird erst durch die Verknüpfung der Ergebnisse aus Spektralanalyse mit den Informationen der demodulierten Funkpakete eine Ursachendiagnose möglich.

Des Weiteren realisieren Ausführungsformen eine automatische Analyse des Funkfrequenzspektrums. Durch die automatische Spektrogramm-Analyse werden erstmalig alle Funksignale spektral erfasst und analysiert. Durch die hohe Detektionswahrscheinlichkeit und -sensitivität der Spektrogramm-Analyse werden neu auftretende aktive Funksysteme oder Funkknoten frühzeitig und sehr schnell erkannt. Paketkollisionen zwischen räumlich benachbarten Funkverbindungen werden ebenfalls automatisch erkannt. Auf Basis der detektierten Funksignale können verschiedene statistische Auswertungen global als auch spezifisch für ausgewählte Funkprotokollen durchgeführt werden. Beispielsweise können statistische Analysen hinsichtlich folgender Parameter durchgeführt werden: Auslastung des jeweiligen Funkfrequenzbandes, Empfangsleistung der Funksignale, Auftrittshäufigkeit der Funksignale, Dauer der Funksignale.

Obwohl manche Aspekte im Zusammenhang mit einer Vorrichtung beschrieben wurden, versteht es sich, dass diese Aspekte auch eine Beschreibung des entsprechenden Verfahrens darstellen, sodass ein Block oder ein Bauelement einer Vorrichtung auch als ein entsprechender Verfahrensschritt oder als ein Merkmal eines Verfahrensschrittes zu verstehen ist. Analog dazu stellen Aspekte, die im Zusammenhang mit einem oder als ein Verfahrensschritt beschrieben wurden, auch eine Beschreibung eines entsprechenden Blocks oder Details oder Merkmals einer entsprechenden Vorrichtung dar. Einige oder alle der Verfahrensschritte können durch einen Hardware-Apparat (oder unter Verwendung eines Hardware-Apparats), wie zum Beispiel einen Mikroprozessor, einen programmierbaren Computer oder einer elektronischen Schaltung durchgeführt werden. Bei einigen Ausführungsbeispielen können einige oder mehrere der wichtigsten Verfahrensschritte durch einen solchen Apparat ausgeführt werden.

Je nach bestimmten Implementierungsanforderungen können Ausführungsbeispiele der Erfindung in Hardware oder in Software oder zumindest teilweise in Hardware oder zumindest teilweise in Software implementiert sein. Die Implementierung kann unter Verwendung eines digitalen Speichermediums, beispielsweise einer Floppy-Disk, einer DVD, einer BluRay Disc, einer CD, eines ROM, eines PROM, eines EPROM, eines EEPROM oder eines FLASH-Speichers, einer Festplatte oder eines anderen magnetischen oder optischen Speichers durchgeführt werden, auf dem elektronisch lesbare Steuersignale gespeichert sind, die mit einem programmierbaren Computersystem derart zusammenwirken können oder zusammenwirken, dass das jeweilige Verfahren durchgeführt wird. Deshalb kann das digitale Speichermedium computerlesbar sein.

Manche Ausführungsbeispiele gemäß der Erfindung umfassen also einen Datenträger, der elektronisch lesbare Steuersignale aufweist, die in der Lage sind, mit einem programmierbaren Computersystem derart zusammenzuwirken, dass eines der hierin beschriebenen Verfahren durchgeführt wird.

Allgemein können Ausführungsbeispiele der vorliegenden Erfindung als Computerprogrammprodukt mit einem Programmcode implementiert sein, wobei der Programmcode dahin gehend wirksam ist, eines der Verfahren durchzuführen, wenn das Computerprogrammprodukt auf einem Computer abläuft.

Der Programmcode kann beispielsweise auch auf einem maschinenlesbaren Träger ge-speichert sein.

Andere Ausführungsbeispiele umfassen das Computerprogramm zum Durchführen eines der hierin beschriebenen Verfahren, wobei das Computerprogramm auf einem maschi-nen-lesbaren Träger gespeichert ist. Mit anderen Worten ist ein Ausführungsbeispiel des erfindungsgemäßen Verfahrens somit ein Computerprogramm, das einen Programmcode zum Durchführen eines der hierin beschriebenen Verfahren aufweist, wenn das Computerprogramm auf einem Computer abläuft.

Ein weiteres Ausführungsbeispiel der erfindungsgemäßen Verfahren ist somit ein Datenträger (oder ein digitales Speichermedium oder ein computerlesbares Medium), auf dem das Computerprogramm zum Durchführen eines der hierin beschriebenen Verfahren aufgezeichnet ist. Der Datenträger oder das digitale Speichermedium oder das computerlesbare Medium sind typischerweise greifbar und/oder nicht flüchtig.

Ein weiteres Ausführungsbeispiel des erfindungsgemäßen Verfahrens ist somit ein Datenstrom oder eine Sequenz von Signalen, der bzw. die das Computerprogramm zum Durchführen eines der hierin beschriebenen Verfahren darstellt bzw. darstellen. Der Datenstrom oder die Sequenz von Signalen kann bzw. können beispielsweise dahin gehend konfiguriert sein, über eine Datenkommunikationsverbindung, beispielsweise über das Internet, transferiert zu werden.

Ein weiteres Ausführungsbeispiel umfasst eine Verarbeitungseinrichtung, beispielsweise einen Computer oder ein programmierbares Logikbauelement, die dahin gehend konfiguriert oder angepasst ist, eines der hierin beschriebenen Verfahren durchzuführen.

Ein weiteres Ausführungsbeispiel umfasst einen Computer, auf dem das Computerprogramm zum Durchführen eines der hierin beschriebenen Verfahren installiert ist.

Ein weiteres Ausführungsbeispiel gemäß der Erfindung umfasst eine Vorrichtung oder ein System, die bzw. das ausgelegt ist, um ein Computerprogramm zur Durchführung zumindest eines der hierin beschriebenen Verfahren zu einem Empfänger zu übertragen. Die Übertragung kann beispielsweise elektronisch oder optisch erfolgen. Der Empfänger kann beispielsweise ein Computer, ein Mobilgerät, ein Speichergerät oder eine ähnliche Vorrichtung sein. Die Vorrichtung oder das System kann beispielsweise einen Datei-Server zur Übertragung des Computerprogramms zu dem Empfänger umfassen.

Bei manchen Ausführungsbeispielen kann ein programmierbares Logikbauelement (beispielsweise ein feldprogrammierbares Gatterarray, ein FPGA) dazu verwendet werden, manche oder alle Funktionalitäten der hierin beschriebenen Verfahren durchzuführen. Bei manchen Ausführungsbeispielen kann ein feldprogrammierbares Gatterarray mit einem Mikroprozessor zusammenwirken, um eines der hierin beschriebenen Verfahren durchzuführen. Allgemein werden die Verfahren bei einigen Ausführungsbeispielen seitens einer beliebigen Hardwarevorrichtung durchgeführt. Diese kann eine universell einsetzbare Hardware wie ein Computerprozessor (CPU) sein oder für das Verfahren spezifische Hardware, wie beispielsweise ein ASIC.

Die oben beschriebenen Ausführungsbeispiele stellen lediglich eine Veranschaulichung der Prinzipien der vorliegenden Erfindung dar. Es versteht sich, dass Modifikationen und Variationen der hierin beschriebenen Anordnungen und Einzelheiten anderen Fachleuten einleuchten werden. Deshalb ist beabsichtigt, dass die Erfindung lediglich durch den Schutzumfang der nachstehenden Patentansprüche und nicht durch die spezifischen Einzelheiten, die anhand der Beschreibung und der Erläuterung der Ausführungsbeispiele hierin präsentiert wurden, beschränkt sei.

### Literaturverzeichnis:

[1] Wetzker, Ulf et. al."Troubleshooting Wireless Coexistence Problems in the Industrial Internet of Things". IEEE Intl. Conference on Embedded and Ubiquitous Computing (EUC), Aug. 2016.
[2] Frotzscher, Andreas "Ist Funk in der Industrie zukunftssicher? ". SPS IPC Drives Messe, Nürnberg, Nov. 2016.
[3] RSA7100A: abrufbar unter: https://www.tek.com/datasheet/rsa7100a .
[4] AirMagnet WiFi Analyzer PRO: abrufbar unter: http://enterprise-de.netscout.com /enterprise-network/wireless-network/AirMagnet-WiFi-Analyzer .
[5] AirMagnet Spectrum XT: abrufbar unter: http://enterprise-de.netscout.com/content/datasheet-airmagnet-spectrum-xt.
[6] US 7 184 777 B2 .
[7] EP 3 170 333 A1 .
[8] US 2003 0198200 A1 .
[9] US 2009 0052500 A1 .
[10] US 2007 0264939 A1 .

## Patentansprüche

1. Vorrichtung zur Analyse von einem oder mehreren Funksystemen, umfassend:
Ein oder mehrere Hochfrequenz-Baugruppen (120; 220; 22S, 221, 22N) zur Erzeugung eines oder mehrerer Basisbandsignale aus einem oder mehreren Funksignalen,
ein Spektralanalysemodul (130; 230) zur Durchführung einer Spektralanalyse, wodurch eines der ein oder mehreren Basisbandsignale in eine Zeit-Frequenz Domäne transformiert wird, um ein Spektrogramm in der Zeit-Frequenz Domäne zu erhalten,
ein oder mehr Demodulatoren (140; 241, 24N) zur Erzeugung von zwei oder mehr demodulierten Funkpaketen der ein oder mehreren Funksysteme aus den ein oder mehreren Basisbandsignalen, wobei die ein oder mehreren Demodulatoren (140; 241, 24N) ferner ausgebildet sind, Zusatzinformationen zu jedem der zwei oder mehreren demodulierten Funkpakete bereitzustellen,
ein Spektrogramm-Analysator (135; 430) zur Detektion von zwei oder mehreren aufgefundenen Funkpaketen in dem Spektrogramm in der Zeit-Frequenz Domäne und zur Ermittlung von ein oder mehreren Eigenschaften für jedes der zwei oder mehreren aufgefundenen Funkpakete basierend auf dem Spektrogramm in der Zeit-Frequenz Domäne, und
ein Synchronisationsmodul (170; 470; 471; 472), das ausgebildet ist, ein oder mehrere Paare zu bestimmen, wobei jedes der ein oder mehreren Paare genau ein demoduliertes Funkpaket der zwei oder mehr demodulierten Funkpakete aufweist und das die ein oder mehreren Eigenschaften von genau einem aufgefundenen Funkpaket der zwei oder mehreren aufgefundenen Funkpakete aufweist,
wobei das Synchronisationsmodul (170; 470; 471; 472) ausgebildet ist, jedes der ein oder mehreren Paare so zu bestimmen, dass die ein oder mehreren Eigenschaften desjenigen in dem Spektrogramm aufgefundenen Funkpakets der zwei oder mehreren aufgefundenen Funkpakete mit dem demodulierten Funkpaket des Paares in dem Paar verknüpft werden, das dem demodulierten Funkpaket des Paares entspricht,
wobei das Synchronisationsmodul (170; 470; 471; 472) ausgebildet ist, jedes der ein oder mehreren Paare in Abhängigkeit von den Zusatzinformationen der zwei oder mehreren demodulierten Funkpakete und in Abhängigkeit von den Eigenschaften der zwei oder mehreren aufgefundenen Funkpakete zu bestimmen, und
wobei das Synchronisationsmodul (170; 470; 471; 472) ausgebildet ist, die ein oder mehreren Paare oder Informationen, die von den ein oder mehreren Paaren abhängen, auszugeben.

2. Vorrichtung nach Anspruch 1,
wobei der Spektrogramm-Analysator (135; 430) einen Paketdetektor (520) zur Detektion der zwei oder mehreren aufgefundenen Funkpakete in dem Spektrogramm in der Zeit-Frequenz Domäne umfasst, und
wobei der Spektrogramm-Analysator (135; 430) eine Zuordnungseinheit (555) zur Zuordnung von ein oder mehreren Eigenschaften zu jedem der zwei oder mehreren aufgefundenen Funkpakete basierend auf dem Spektrogramm in der Zeit-Frequenz Domäne umfasst, wobei es sich bei den ein oder mehreren Eigenschaften der zwei oder mehreren aufgefundenen Funkpakete zumindest um einen Empfangszeitpunkt eines der zwei oder mehreren aufgefundenen Funkpakete oder eine Trägerfrequenz oder um eine Bandbreite oder um eine Empfangsleistung oder um eine zeitliche Dauer des einen der zwei oder mehreren aufgefundenen Funkpakete oder um ein Leistungsspektrum des einen der zwei oder mehreren aufgefundenen Funkpakete handelt.

3. Vorrichtung nach Anspruch 2,
wobei der Rauschleistungsdetektor (510) ausgelegt ist, die Rauschleistung in dem Spektrogramm zu schätzen,
wobei der Paketdetektor (520) ausgelegt ist, Leistungswerte oder Leistungsdichtewerte im Spektrogramm, die kleiner oder gleich einem Grenzwert sind, der von der Rauschleistung abhängt, im Spektrogramm als Bereiche in der Zeit-Frequenz Domäne zu bestimmen, in denen kein Funkpaket vorliegt, und
wobei der Paketdetektor (520) ausgelegt ist, Bereiche in der Zeit-Frequenz Domäne, die Leistungswerte oder die Leistungsdichtewerte größer dem Grenzwert aufweisen, als Bereiche in der Zeit-Frequenz Domäne zu bestimmen, in denen ein Funkpaket vorliegt.

4. Vorrichtung nach Anspruch 2,
wobei der Rauschleistungsdetektor (510) ausgelegt ist, die Rauschleistung in dem Spektrogramm zu schätzen,
wobei der Rauschleistungsdetektor (510) ausgelegt ist, Leistungswerte oder Leistungsdichtewerte, die kleiner oder gleich einem Grenzwert sind, der von der Rauschleistung abhängt, im Spektrogramm auf den Wert Null zu setzen,
wobei der Paketdetektor (520) ausgelegt ist, Leistungswerte oder Leistungsdichtewerte im Spektrogramm, die gleich Null sind, im Spektrogramm als Bereiche in der Zeit-Frequenz Domäne zu bestimmen, in denen kein Funkpaket vorliegt, und
wobei der Paketdetektor (520) ausgelegt ist, Bereiche in der Zeit-Frequenz Domäne, die Leistungswerte oder die Leistungsdichtewerte größer als Null aufweisen, als Bereiche in der Zeit-Frequenz Domäne zu bestimmen, in denen ein Funkpaket vorliegt.

5. Vorrichtung nach einem der Ansprüche 2 bis 4,
wobei der Spektrogramm-Analysator (135; 430) einen Paketkollisionsdetektor (540) aufweist,
wobei der Paketkollisionsdetektor (540) ausgebildet ist, für jedes der zwei oder mehreren aufgefundenen Funkpakete basierend auf dem Spektrogramm in der Zeit-Frequenz Domäne festzustellen, ob es für dieses aufgefundene Funkpaket zu einer Kollision mit einem anderen der zwei oder mehreren aufgefundenen Funkpakete gekommen ist,
wobei die Zuordnungseinheit (555) ausgebildet ist, diesem aufgefundenen Funkpaket als eine der ein oder mehreren Eigenschaften die Information zuzuordnen, dass es zu einer Kollision mit einem anderen der zwei oder mehreren aufgefundenen Funkpakete gekommen ist,
wobei das Synchronisationsmodul (170; 470; 471; 472) ausgebildet ist, ein Paar der ein oder mehreren Paare so zu bestimmen, dass das genau eine demodulierte Funkpaket dieses Paares dasjenige Funkpaket ist, das dem im Spektrogramm aufgefundenen Funkpaket entspricht, bei dem es zu einer Kollision mit einem anderen Funkpaket gekommen ist, und dass eine der ein oder mehreren Eigenschaften des Paares die Information ist, dass es bei dem demodulierten Funkpaket dieses Paares zu einer Kollision gekommen ist,
wobei das Synchronisationsmodul (170; 470; 471; 472) ausgebildet ist, die Information auszugeben, dass es bei dem demodulierten Funkpaket dieses Paares zu einer Kollision gekommen ist.

6. Vorrichtung nach Anspruch 5,
wobei der Paketkollisionsdetektor (540) ausgebildet ist, für zwei Funkpakete der zwei oder mehreren aufgefundenen Funkpakete festzustellen, ob diese Funkpakete miteinander kollidieren, indem der Paketkollisionsdetektor (540) in der Zeit-Frequenz Domäne des Spektrogramms feststellt, ob diese zwei Funkpakete überschneidungsfrei sind oder nicht.

7. Vorrichtung nach Anspruch 5 oder 6,
wobei das Synchronisationsmodul (170; 470; 471; 472) ausgebildet ist, eine Information über ein Funkprotokoll eines anderen Funkpakets auszugeben, mit dem das aufgefundene Funkpaket, das dem demodulierte Funkpaket dieses Paares entspricht, eine Kollision gehabt hat.

8. Vorrichtung nach einem der Ansprüche 2 bis 7,
wobei der Spektrogramm-Analysator (135; 430) einen Merkmalsextraktor (530) aufweist,
wobei der Merkmalsextraktor (530) ausgebildet ist, für jedes der zwei oder mehreren aufgefundenen Funkpakete basierend auf dem Spektrogramm in der Zeit-Frequenz Domäne festzustellen, ob dieses aufgefundene Funkpaket eine Störung im Spektrogramm aufweist,
wobei die Zuordnungseinheit (555) ausgebildet ist, diesem aufgefundenen Funkpaket als eine der ein oder mehreren Eigenschaften die Information zuzuordnen, dass dieses aufgefundene Funkpaket eine Störung im Spektrogramm aufweist,
wobei das Synchronisationsmodul (170; 470; 471; 472) ausgebildet ist, ein Paar der ein oder mehreren Paare so zu bestimmen, dass das genau eine demodulierte Funkpaket dieses Paares dasjenige Funkpaket ist, das dem im Spektrogramm aufgefundenen Funkpaket entspricht, das eine Störung im Spektrogramm aufweist, und dass eine der ein oder mehreren Eigenschaften des Paares die Information ist, dass das demodulierten Funkpaket dieses Paares unter Auftreten einer Störung übertragen wurde,
wobei das Synchronisationsmodul (170; 470; 471; 472) ausgebildet ist, die Information auszugeben, dass das demodulierten Funkpaket dieses Paares unter Auftreten einer Störung übertragen wurde.

9. Vorrichtung nach Anspruch 8,
wobei der Merkmalsextraktor (530) ausgebildet ist, für ein Funkpaket der zwei oder mehreren aufgefundenen Funkpakete basierend auf dem Spektrogramm in der Zeit-Frequenz Domäne festzustellen, ob dieses aufgefundene Funkpaket eine Störung im Spektrogramm aufweist, indem der Merkmalsextraktor (530) ermittelt, ob ein Leistungsdichtespektrum des Funkpakets in einer Frequenz-Leistungsdichte Domäne des Spektrogramms eine Asymmetrie aufweist.

10. Vorrichtung nach Anspruch 8,
wobei der Merkmalsextraktor (530) ausgebildet ist, für ein Funkpaket der zwei oder mehreren aufgefundenen Funkpakete basierend auf dem Spektrogramm in der Zeit-Frequenz Domäne festzustellen, ob dieses aufgefundene Funkpaket eine Störung im Spektrogramm aufweist, indem der Merkmalsextraktor (530) ein tatsächliches Leistungsdichtespektrum des Funkpakets in einer Frequenz-Leistungsdichte Domäne mit einer vordefinierten spektralen Maske vergleicht.

11. Vorrichtung nach Anspruch 10,
wobei der Merkmalsextraktor (530) ausgebildet ist, die vordefinierte spektrale Maske aus einer Datenbank in Abhängigkeit von einem Funkprotokoll des aufgefundenen Funkpakets zu laden.

12. Vorrichtung nach einem der Ansprüche 1 bis 11,
wobei das Synchronisationsmodul (170; 472) ausgebildet ist,
mindestens eine Eigenschaft der ein oder mehreren Eigenschaften eines in dem Spektrogramm aufgefundenen Funkpakets der zwei oder mehreren aufgefundenen Funkpakete
mit einer Information aus den Zusatzinformationen eines demodulierten Funkpakets der zwei oder mehreren demodulierten Funkpakete miteinander zu vergleichen,
um festzustellen, ob dieses in dem Spektrogramm aufgefundene Funkpakets diesem demodulierten Funkpaket entspricht.

13. Vorrichtung nach einem der Ansprüche 1 bis 11,
wobei das Synchronisationsmodul (170; 471) ausgebildet ist, ein quantisiertes Spektrogramm basierend auf den ein oder mehreren Eigenschaften eines in dem Spektrogramm aufgefundenen Funkpakets der zwei oder mehreren aufgefundenen Funkpakete zu berechnen,
wobei das Synchronisationsmodul (170; 471) ausgebildet ist, ein virtuelles Spektrogramm basierend auf den Zusatzinformationen zu einem der zwei oder mehreren demodulierten Funkpakete zu berechnen, und
wobei das Synchronisationsmodul (170; 471) ausgebildet ist, das quantisierte Spektrogramm und das virtuelle Spektrogramm miteinander zu vergleichen, um festzustellen, ob dieses in dem Spektrogramm aufgefundene Funkpakets diesem demodulierten Funkpaket entspricht.

14. Vorrichtung nach einem der vorherigen Ansprüche,
wobei die Vorrichtung des Weiteren ein oder mehrere Antennen (210; 21S, 211, 21N) zum Erfassen der ein oder mehreren Funksignale umfasst.

15. Von einer Vorrichtung ausgeführtes Verfahren zur Analyse von einem oder mehreren Funksystemen, umfassend:
Erzeugung eines oder mehrerer Basisbandsignale aus einem oder mehreren Funksignalen,
Durchführung einer Spektralanalyse, wodurch eines der ein oder mehreren Basisbandsignale in eine Zeit-Frequenz Domäne transformiert wird, um ein Spektrogramm in der Zeit-Frequenz Domäne zu erhalten,
Erzeugung von zwei oder mehr demodulierten Funkpaketen der ein oder mehreren Funksysteme aus den ein oder mehreren Basisbandsignalen, und Bereitstellung von Zusatzinformationen zu jedem der zwei oder mehreren demodulierten Funkpakete,
Detektion von zwei oder mehreren aufgefundenen Funkpaketen in dem Spektrogramm in der Zeit-Frequenz Domäne, und Ermittlung von ein oder mehreren Eigenschaften für jedes der zwei oder mehreren aufgefundenen Funkpakete basierend auf dem Spektrogramm in der Zeit-Frequenz Domäne, und
Bestimmung von ein oder mehreren Paaren, wobei jedes der ein oder mehreren Paare genau ein demoduliertes Funkpaket der zwei oder mehr demodulierten Funkpakete aufweist und das die ein oder mehreren Eigenschaften von genau einem aufgefundenen Funkpaket der zwei oder mehreren aufgefundenen Funkpakete aufweist,
wobei jedes der ein oder mehreren Paare so bestimmt wird, dass die ein oder mehreren Eigenschaften desjenigen in dem Spektrogramm aufgefundenen Funkpakets der zwei oder mehreren aufgefundenen Funkpakete mit dem demodulierten Funkpaket des Paares in dem Paar verknüpft werden, das dem demodulierten Funkpaket des Paares entspricht,
wobei jedes der ein oder mehreren Paare in Abhängigkeit von den Zusatzinformationen der zwei oder mehreren demodulierten Funkpakete und in Abhängigkeit von den Eigenschaften der zwei oder mehreren aufgefundenen Funkpakete bestimmt wird, und
Ausgabe der ein oder mehreren Paare oder von Informationen, die von den ein oder mehreren Paaren abhängen.

16. Computerprogramm mit einem Programmcode, der bei der Ausführung des Programms durch eine Vorrichtung diese veranlasst, die Schritte des Verfahrens nach Anspruch 15 auszuführen.

## Claims

1. An apparatus for analyzing one or several radio systems, comprising:
one or several radio-frequency units (120; 220; 22S, 221, 22N) for generating one or several baseband signals from one or several radio signals,
a spectral analysis module (130; 230) for performing spectral analysis, wherein one of the one or several baseband signals is transformed to a time-frequency domain in order to obtain a spectrogram in the time-frequency domain,
one or several demodulators (140; 241, 24N) for generating two or more demodulated radio packets of the one or several radio systems from the one or several baseband signals, said one or several demodulators (140; 241, 24N) being configured to provide additional information for each of the two or several demodulated radio packets,
a spectrogram analyzer (135; 430) for detecting two or several radio packets found in the spectrogram in the time-frequency domain and for establishing one or several characteristics for each of the two or several radio packets found based on the spectrogram in the time-frequency domain, and
a synchronization module (170; 470; 471; 472) configured to determine one or several pairs, wherein each of the one or several pairs comprises precisely one demodulated radio packet of the two or more demodulated radio packets and comprising the one or several characteristics of precisely one radio packet found of the two or several radio packets found,
wherein the synchronization module (170; 470; 471; 472) is configured to determine each of the one or several pairs such that the one or several characteristics of that radio packet found in the spectrogram of the two or several radio packets found is/are associated to the demodulated radio packet of the pair in that pair which corresponds to the demodulated radio packet of the pair,
wherein the synchronization module (170; 470; 471; 472) is configured to determine each of the one or several pairs in dependence on the additional information of the two or several demodulated radio packets and in dependence on the characteristics of the two or several radio packets found, and
wherein the synchronization module (170; 470; 471; 472) is configured to output the one or several pairs or information depending on the one or several pairs.

2. The apparatus in accordance with claim 1,
wherein the spectrogram analyzer (135; 430) comprises a packet detector (520) for detecting the two or several radio packets found in the spectrogram in the time-frequency domain, and
wherein the spectrogram analyzer (135; 430) comprises an allocation unit (555) for allocating one or several characteristics to each of the two or several radio packets found based on the spectrogram in the time-frequency domain, wherein the one or several characteristics of the two or several radio packets found is/are at least a receive time of one of the two or several radio packets found or a carrier frequency or a bandwidth or a receive power or a duration of the one of the two or several radio packets found or a power spectrum of the one of the two or several radio packets found.

3. The apparatus in accordance with claim 2,
wherein the noise power detector (510) is configured to estimate the noise power in the spectrogram,
wherein the packet detector (520) is configured to determine power values or power density values in the spectrogram which are smaller than or equaling a threshold value which depends on the noise power, in the spectrogram to be regions in the time-frequency domain where there is no radio packet, and
wherein the packet detector (520) is configured to determine regions in the time-frequency domain which comprise power values or power density values greater than the threshold value, to be regions in the time-frequency domain where there is a radio packet.

4. The apparatus in accordance with claim 2,
wherein the noise power detector (510) is configured to estimate the noise power in the spectrogram,
wherein the noise power detector (510) is configured to set power values or power density values which are smaller than or equaling a threshold value which depends on the noise power, in the spectrogram to zero,
wherein the packet detector (520) is configured to determine power values or power density values in the spectrogram, which equal zero, in the spectrogram to be regions in the time-frequency domain where there is no radio packet, and
wherein the packet detector (520) is configured to determine regions in the time-frequency domain which comprise power values or power density values greater than zero, to be regions in the time-frequency domain where there is a radio packet.

5. The apparatus in accordance with any of claims 2 to 4,
wherein the spectrogram analyzer (135; 430) comprises a packet collision detector (540),
wherein the packet collision detector (540) is configured to establish for each of the two or several radio packets found based on the spectrogram in the time-frequency domain whether a collision has occurred for this radio packet found with another one of the two or several radio packets found,
wherein the allocation unit (555) is configured to allocate to this radio packet found, as one of the one or several characteristics, the information indicating that a collision has occurred with another one of the two or several radio packets found,
wherein the synchronization module (170; 470; 471; 472) is configured to determine a pair of the one or several pairs such that the precisely one demodulated radio packet of this pair is that radio packet which corresponds to the radio packet found in the spectrogram where there has been a collision with another radio packet, and that one of the one or several characteristics of the pair is the information indicating that there has been a collision in the demodulated radio packet of this pair,
wherein the synchronization module (170; 470; 471; 472) is configured to output the information indicating that there has been a collision in the demodulated radio packet of this pair.

6. The apparatus in accordance with claim 5,
wherein the packet collision detector (540) is configured to establish for two radio packets of the two or several radio packets found whether these radio packets collide with each other, wherein the packet collision detector (540) establishes in the time-frequency domain of the spectrogram whether these two radio packets are free from superpositioning or not.

7. The apparatus in accordance with claim 5 or 6,
wherein the synchronization module (170; 470; 471; 472) is configured to output information on a radio protocol of another radio packet which the radio packet found, which corresponds to the demodulated radio packet of this pair, has collided with.

8. The apparatus in accordance with any of claims 2 to 7,
wherein the spectrogram analyzer (135; 430) comprises a feature extractor (530),
wherein the feature extractor (530) is configured to establish for each of the two or several radio packets found based on the spectrogram in the time-frequency domain whether this radio packet found comprises a fault in the spectrogram,
wherein the allocation unit (555) is configured to allocate to this radio packet found, as one of the one or several characteristics, the information indicating that this radio packet found comprises a fault in the spectrogram,
wherein the synchronization module (170; 470; 471; 472) is configured to determine a pair of the one or several pairs such that the precisely one demodulated radio packet of this pair is that radio packet which corresponds to the radio packet found in the spectrogram comprising a fault in the spectrogram, and that one of the one or several characteristics of the pair is the information indicating that the demodulated radio packet of this pair has been transmitted with a fault occurring,
wherein the synchronization module (170; 470; 471; 472) is configured to output the information indicating that the demodulated radio packet of this pair has been transmitted with a fault occurring.

9. The apparatus in accordance with claim 8,
wherein the feature extractor (530) is configured to establish for a radio packet of the two or several radio packets found based on the spectrogram in the time-frequency domain whether this radio packet found comprises a fault in the spectrogram, wherein the feature extractor (530) establishes whether a power density spectrum of the radio packet comprises an asymmetry in a frequency-power density domain of the spectrogram.

10. The apparatus in accordance with claim 8,
wherein the feature extractor (530) is configured to establish for a radio packet of the two or several radio packets found based on the spectrogram in the time-frequency domain whether this radio packet found comprises a fault in the spectrogram, wherein the feature extractor (530) compares an actual power density spectrum of the radio packet in a frequency-power density domain to a predefined spectral mask.

11. The apparatus in accordance with claim 10,
wherein the feature extractor (530) is configured to load the predefined spectral mask from a database in dependence on a radio protocol of the radio packet found.

12. The apparatus in accordance with any of claims 1 to 11,
wherein the synchronization module (170; 472) is configured to compare:
at least one characteristic of the one or several characteristics of a radio packet found in the spectrogram of the two or several radio packets found
to information from the additional information of a demodulated radio packet of the two or several demodulated radio packets
in order to establish whether this radio packet found in the spectrogram corresponds to this demodulated radio packet.

13. The apparatus in accordance with any of claims 1 to 11,
wherein the synchronization module (170; 471) is configured to calculate a quantized spectrogram based on the one or several characteristics of a radio packet found in the spectrogram of the two or several radio packets found,
wherein the synchronization module (170; 471) is configured to calculate a virtual spectrogram based on the additional information for one of the two or several demodulated radio packets, and
wherein the synchronization module (170; 471) is configured to compare the quantized spectrogram and the virtual spectrogram to each other in order to establish whether this radio packet found in the spectrogram corresponds to this demodulated radio packet.

14. The apparatus in accordance with any of the preceding claims,
wherein the apparatus additionally comprises one or several antennas (210; 21S, 211, 21N) for detecting the one or several radio signals.

15. A method for analyzing one or several radio systems performed by an apparatus, comprising the steps of:
generating one or several baseband signals from one or several radio signals,
performing spectral analysis, wherein one of the one or several baseband signals is transformed to a time-frequency domain in order to obtain a spectrogram in the time-frequency domain,
generating two or more demodulated radio packets of the one or several radio systems from the one or several baseband signals and providing additional information for each of the two or more demodulated radio packets,
detecting two or several radio packets found in the spectrogram in the time-frequency domain and establishing one or several characteristics for each of the two or several radio packets found based on the spectrogram in the time-frequency domain, and
determining one or several pairs, wherein each of the one or several pairs comprises precisely one demodulated radio packet of the two or more demodulated radio packets and comprising the one or several characteristics of precisely one radio packet found of the two or several radio packets found,
wherein each of the one or several pairs is determined such that the one or several characteristics of that radio packet found in the spectrogram of the two or several radio packets found is/are associated with the demodulated radio packet of the pair in the pair corresponding to the demodulated radio packet of the pair,
wherein each of the one or several pairs is determined in dependence on the additional information of the two or several demodulated radio packets and in dependence on the characteristics of the two or several radio packets found, and
outputting the one or several pairs or information depending on the one or several pairs.

16. A computer program comprising program code, which, when the program is executed by an apparatus, causes the same to perform the steps of the method in accordance with claim 15.

## Revendications

1. Dispositif d'analyse d'un ou plusieurs systèmes radio, comportant:
un ou plusieurs modules de haute fréquence (120; 220; 22S, 221, 22N) destinés à générer un ou plusieurs signaux de bande de base à partir d'un ou plusieurs signaux radio,
un module d'analyse spectrale (130; 230) destiné à effectuer une analyse spectrale à la suite de laquelle un des un ou plusieurs signaux de bande de base est transformé à un domaine temps-fréquence pour obtenir un spectrogramme dans le domaine temps-fréquence,
un ou plusieurs démodulateurs (140; 241, 24N) destinés à générer deux ou plusieurs paquets radio démodulés des un ou plusieurs systèmes radio à partir des un ou plusieurs signaux de bande de base, où les un ou plusieurs démodulateurs (140; 241, 24N) sont par ailleurs conçus pour fournir des informations additionnelles pour chacun des deux ou plusieurs paquets radio démodulés,
un analyseur de spectrogramme (135; 430) destiné à détecter deux ou plusieurs paquets radio trouvés dans le spectrogramme dans le domaine temps-fréquence et à déterminer une ou plusieurs propriétés pour chacun des deux ou plusieurs paquets radio trouvés sur base du spectrogramme dans le domaine temps-fréquence, et
un module de synchronisation (170; 470; 471; 472) qui est conçu pour déterminer une ou plusieurs paires, où chacune des une ou plusieurs paires présente exactement un paquet radio démodulé des deux ou plusieurs paquets radio démodulés et qui présente les une ou plusieurs propriétés d'exactement un paquet radio trouvé parmi les deux ou plusieurs paquets radio trouvés,
dans lequel le module de synchronisation (170; 470; 471; 472) est conçu pour déterminer chacune des une ou plusieurs paires de sorte que les une ou plusieurs propriétés du paquet radio trouvé parmi les deux ou plusieurs paquets radio trouvés dans le spectrogramme soient couplées au paquet radio démodulé de la paire dans la paire qui correspond au paquet radio démodulé de la paire,
dans lequel le module de synchronisation (170; 470; 471; 472) est conçu pour déterminer chacune des une ou plusieurs paires en fonction des informations additionnelles des deux ou plusieurs paquets radio démodulés et en fonction des propriétés des deux ou plusieurs paquets radio trouvés, et
dans lequel le module de synchronisation (170; 470; 471; 472) est conçu pour sortir les une ou plusieurs paires ou les informations qui dépendent des une ou plusieurs paires.

2. Dispositif selon la revendication 1,
dans lequel l'analyseur de spectrogramme (135; 430) comporte un détecteur de paquets (520) destiné à détecter les deux ou plusieurs paquets radio trouvés dans le spectrogramme dans le domaine temps-fréquence, et
dans lequel l'analyseur de spectrogramme (135; 430) comporte une unité d'association (555) destinée à associer une ou plusieurs propriétés à chacun des deux ou plusieurs paquets radio trouvés sur base du spectrogramme dans le domaine temps-fréquence, dans lequel il s'agit, pour les une ou plusieurs propriétés des deux ou plusieurs paquets radio trouvés, au moins d'un moment de réception d'un des deux ou plusieurs paquets radio trouvés ou d'une fréquence porteuse ou d'une largeur de bande ou d'une puissance de réception ou d'une durée dans le temps de l'un des deux ou plusieurs paquets radio trouvés ou d'un spectre de puissance de l'un des deux ou plusieurs paquets radio trouvés.

3. Dispositif selon la revendication 2,
dans lequel le détecteur de puissance de bruit (510) est conçu pour estimer la puissance de bruit dans le spectrogramme,
dans lequel le détecteur de paquets (520) est conçu pour déterminer, dans le spectrogramme, les valeurs de puissance ou valeurs de densité de puissance dans le spectrogramme qui sont inférieures ou égales à une valeur limite qui dépend de la puissance de bruit comme zones dans le domaine temps-fréquence dans lesquelles n'est pas présent de paquet radio, et
dans lequel le détecteur de paquets (520) est conçu pour déterminer les zones dans le domaine temps-fréquence qui présentent des valeurs de puissance ou des valeurs de densité de puissance supérieures à la valeur limite comme zones dans le domaine temps-fréquence dans lesquelles est présent un paquet radio.

4. Dispositif selon la revendication 2,
dans lequel le détecteur de puissance de bruit (510) est configuré pour estimer la puissance de bruit dans le spectrogramme,
dans lequel le détecteur de puissance de bruit (510) est conçu pour régler à la valeur zéro, dans le spectrogramme, les valeurs de puissance ou valeurs de densité de puissance qui sont inférieures ou égales à une valeur limite qui dépend de la puissance de bruit,
dans lequel le détecteur de paquets (520) est conçu pour déterminer, dans le spectrogramme, les valeurs de puissance ou valeurs de densité de puissance dans le spectrogramme qui sont égales à zéro comme zones dans le domaine temps-fréquence dans lesquelles n'est pas présent de paquet radio, et
dans lequel le détecteur de paquets (520) est conçu pour déterminer les zones dans le domaine temps-fréquence qui présentent des valeurs de puissance ou valeurs de densité de puissance supérieures à zéro comme zones dans le domaine temps-fréquence dans lesquelles est présent un paquet radio.

5. Dispositif selon l'une des revendications 2 à 4,
dans lequel l'analyseur de spectrogramme (135; 430) comporte un détecteur de collision de paquets (540),
dans lequel le détecteur de collision de paquets (540) est conçu pour constater, pour chacun des deux ou plusieurs paquets radio trouvés, sur base du spectrogramme dans le domaine temps-fréquence, s'il s'est produit, pour ce paquet radio trouvé, une collision avec un autre des deux ou plusieurs paquets radio trouvés,
dans lequel l'unité d'association (555) est conçue pour associer à ce paquet radio trouvé, comme une des une ou plusieurs propriétés, l'information qu'il s'est produit une collision avec un autre des deux ou plusieurs paquets radio trouvés,
dans lequel le module de synchronisation (170; 470; 471; 472) est conçu pour déterminer une paire des une ou plusieurs paires de sorte qu'exactement un paquet radio démodulé de cette paire soit le paquet radio qui correspond au paquet radio trouvé dans le spectrogramme dans le cas duquel il s'est produit une collision avec un autre paquet radio, et qu'une des une ou plusieurs propriétés de la paire soit l'information qu'il s'est produit une collision avec le paquet radio démodulé de cette paire,
dans lequel le module de synchronisation (170; 470; 471; 472) est conçu pour sortir l'information qu'il s'est produit une collision dans le cas du paquet radio démodulé de cette paire.

6. Dispositif selon la revendication 5,
dans lequel le détecteur de collision de paquets (540) est conçu pour constater, pour deux paquets radio des deux ou plusieurs paquets radio trouvés, si ces paquets radio entrent en collision l'un avec l'autre en ce que le détecteur de collision de paquets (540) dans le domaine temps-fréquence du spectrogramme détecte si ces deux paquets radio sont ou non exempts de chevauchement.

7. Dispositif selon la revendication 5 ou 6,
dans lequel le module de synchronisation (170; 470; 471; 472) est conçu pour sortir une information sur un protocole radio d'un autre paquet radio avec lequel le paquet radio trouvé qui correspond au paquet radio démodulé de cette paire est entré en collision.

8. Dispositif selon l'une des revendications 2 à 7,
dans lequel l'analyseur de spectrogramme (135; 430) présente un extracteur de caractéristiques (530),
dans lequel l'extracteur de caractéristiques (530) est conçu pour constater, pour chacun des deux ou plusieurs paquets radio trouvés, sur base du spectrogramme dans le domaine temps-fréquence, si ce paquet radio trouvé présente une perturbation dans le spectrogramme,
dans lequel l'unité d'association (555) est conçue pour associer à ce paquet radio trouvé, comme une des une ou plusieurs propriétés, l'information que ce paquet radio trouvé présente une perturbation dans le spectrogramme,
dans lequel le module de synchronisation (170; 470; 471; 472) est conçu pour déterminer une paire des une ou plusieurs paires de sorte qu'exactement un paquet radio démodulé de cette paire soit le paquet radio qui correspond au paquet radio trouvé dans le spectrogramme qui présente une perturbation dans le spectrogramme, et qu'une des une ou plusieurs propriétés de la paire soit l'information que le paquet radio démodulé de cette paire a été transmis avec production d'une perturbation,
dans lequel le module de synchronisation (170 ; 470 ; 471 ; 472) est conçu pour sortir l'information que le paquet radio démodulé de cette paire a été transmis avec production d'une perturbation.

9. Dispositif selon la revendication 8,
dans lequel l'extracteur de caractéristiques (530) est conçu pour constater, pour un paquet radio des deux ou plusieurs paquets radio trouvés, sur base du spectrogramme dans le domaine temps-fréquence, si ce paquet radio trouvé présente une perturbation dans le spectrogramme en ce que l'extracteur de caractéristiques (530) détermine si un spectre de densités de puissance du paquet radio dans un domaine de fréquence-densité de puissance du spectrogramme présente une asymétrie.

10. Dispositif selon la revendication 8,
dans lequel l'extracteur de caractéristiques (530) est conçu pour constater, pour un paquet radio des deux ou plusieurs paquets radio trouvés, sur base du spectrogramme dans le domaine temps-fréquence, si ce paquet radio trouvé présente une perturbation dans le spectrogramme en ce que l'extracteur de caractéristiques (530) compare un spectre de densité de puissance réel du paquet radio dans un domaine de fréquence-densité de puissance avec un masque spectral prédéfini.

11. Dispositif selon la revendication 10,
dans lequel l'extracteur de caractéristiques (530) est conçu pour charger le masque spectral prédéfini à partir d'une base de données en fonction d'un protocole radio du paquet radio trouvé.

12. Dispositif selon l'une des revendications 1 à 11,
dans lequel le module de synchronisation (170 ; 472) est conçu pour
comparer entre elles au moins une propriété des une ou plusieurs propriétés d'un paquet radio trouvé dans le spectrogramme des deux ou plusieurs paquets radio
avec une information des informations additionnelles d'un paquet radio démodulé des deux ou plusieurs paquets radio démodulés
pour constater si ce paquet radio trouvé dans le spectrogramme correspond à ce paquet radio démodulé.

13. Dispositif selon l'une des revendications 1 à 11,
dans lequel le module de synchronisation (170; 471) est conçu pour calculer un spectrogramme quantifié sur base des une ou plusieurs propriétés d'un paquet radio trouvé dans le spectrogramme des deux ou plusieurs paquets radio,
dans lequel le module de synchronisation (170; 471) est conçu pour calculer un spectrogramme virtuel sur base des informations additionnelles relatives à un des deux ou plusieurs paquets radio démodulés, et
dans lequel le module de synchronisation (170; 471) est conçu pour comparer entre eux le spectrogramme quantifié et le spectrogramme virtuel pour constater si ce paquet radio trouvé dans le spectrogramme correspond à ce paquet radio démodulé.

14. Dispositif selon l'une des revendications précédentes,
dans lequel le dispositif comporte par ailleurs une ou plusieurs antennes (210; 21S, 211, 21N) destinées à détecter les un ou plusieurs signaux radio.

15. Procédé d'analyse d'un ou plusieurs systèmes radio réalisé par un dispositif, comprenant le fait de:
générer un ou plusieurs signaux de bande de base à partir d'un ou plusieurs signaux radio,
effectuer une analyse spectrale par laquelle un des un ou plusieurs signaux de bande de base est transformé à un domaine temps-fréquence pour obtenir un spectrogramme dans le domaine temps-fréquence,
générer deux ou plusieurs paquets radio démodulés des un ou plusieurs systèmes radio à partir des un ou plusieurs signaux de bande de base, et fournir des informations additionnelles sur chacun des deux ou plusieurs paquets radio démodulés,
détecter deux ou plusieurs paquets radio trouvés dans le spectrogramme dans le domaine temps-fréquence, et déterminer une ou plusieurs propriétés pour chacun des deux ou plusieurs paquets radio trouvés sur base du spectrogramme dans le domaine temps-fréquence, et
déterminer une ou plusieurs paires, où chacune des une ou plusieurs paires présente exactement un paquet radio démodulé des deux ou plusieurs paquets radio démodulés et qui présente les une ou plusieurs propriétés d'exactement un paquet radio trouvé des deux ou plusieurs paquets radio trouvés,
dans lequel chacune des une ou plusieurs paires est déterminée de sorte que les une ou plusieurs propriétés du paquet radio trouvé dans le spectrogramme des deux ou plusieurs paquets radio trouvés soient couplées au paquet radio démodulé de la paire dans la paire qui correspond au paquet radio démodulé de la paire,
dans lequel chacune des une ou plusieurs paires est déterminée en fonction des informations additionnelles des deux ou plusieurs paquets radio démodulés et en fonction des propriétés des deux ou plusieurs paquets radio trouvés, et
sortir les une ou plusieurs paires ou les informations qui dépendent des une ou plusieurs paires.

16. Programme d'ordinateur avec un code de programme qui, lorsque le programme est exécuté par un dispositif, amène ce dernier à réaliser les étapes du procédé selon la revendication 15.
